# EUROPEAN PATENT SPECIFICATION

(11) **EP 4 372 811 B1**
(45) Date of publication and mention of the grant of the patent: **21.10.2026**
(21) Application number: 22207783.6
(22) Date of filing: 16.11.2022
(51) Int. Cl.: H10W 70/60, H10W 42/60

(54) **COMPONENT CARRIER WITH ROWS OF EQUIDISTANT WIRING ELEMENTS AND FURTHER WIRING ELEMENTS AT DIFFERENT LEVEL CONNECTED TO MUTUALLY SPACED CONDUCTIVE AREAS**
KOMPONENTENTRÄGER MIT ZEILEN VON ÄQUIDISTANTEN VERDRAHTUNGSELEMENTEN UND WEITEREN VERDRAHTUNGSELEMENTEN AUF UNTERSCHIEDLICHEN EBENEN, DIE MIT VONEINANDER BEABSTANDETEN LEITFÄHIGEN BEREICHEN VERBUNDEN SIND
SUPPORT DE COMPOSANTS AVEC DES RANGÉES D'ÉLÉMENTS DE CÂBLAGE ÉQUIDISTANTS ET D'AUTRES ÉLÉMENTS DE CÂBLAGE À DIFFÉRENTS NIVEAUX RELIÉS À DES ZONES CONDUCTRICES ESPACÉES

(43) Date of publication of application: 22.05.2024
(73) Proprietor: AT & S Austria Technologie & Systemtechnik Aktiengesellschaft, 8700 Leoben (AT)
(72) Inventor: Oggioni, Stefano Sergio, 8700 Leoben (AT)
(74) Representative: Donatello, Daniele

(56) References cited:
- JP-A- 2018 098 339
- US-A1- 2016 043 051
- US-A1- 2017 018 478
- US-A1- 2018 168 039

## Description

The invention relates to a component carrier, and a method of manufacturing a component carrier.

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. At the same time, component carriers shall be mechanically robust and electrically reliable so as to be operable even under harsh conditions.

Designing component carriers for achieving compliance with one or more target requirements, for instance defined by a specification, may be difficult, in particular when surface mounting at least one powerful electronic component on the component carrier.

Document US 2016/043051 A1 discloses a component carrier having a plurality of wiring elements distributed in several rows in a plurality of stacked layers, to vertically connect the bumps connected to a die on one main surface of the carrier to the opposed main surface thereof; additional horizontal peripheral traces are provided on the main surface of the carrier connected to other bumps connected to the die and extending externally.

Document US 2017/018478 A1 discloses a component carrier having a thermal dissipation layout composed of a plurality of vias connected to common planar pads connecting the carrier from one side where a die is provided toward the opposed side where an exposed pad is formed.

Document JP 2018 098339 A discloses component carrier having a plurality of wiring elements with different functions (i.e. power, ground functions) equally distributed at the specific plan-layer in accordance to a rule defining the positioning of the wiring elements at the vertex of scalene/isosceles triangles.

It is an object of the invention to enable manufacture of component carriers for achieving compliance with one or more target requirements.

In order to achieve the object defined above, a component carrier, and a method of manufacturing a component carrier according to the independent claims are provided.

According to the invention, a component carrier is provided which comprises a stack comprising at least two electrically insulating layer structures and at least one electrically conductive layer structure (preferably a plurality of electrically conductive layer structures), a plurality of wiring elements provided in one of the at least two electrically insulating layer structures, said plurality of wiring elements being arranged in a wiring plane to form a first row of equidistant wiring elements arranged along a straight direction within the wiring plane, and a second row of equidistant wiring elements arranged along the straight direction within the wiring plane, a plurality of further wiring elements provided in another of the at least two electrically insulating layer structures, wherein the at least one electrically conductive layer structure comprises several conductive areas (which may be planar, such as land pads) being electrically insulated with respect to each other, each of said conductive areas being connected to at least one of the plurality of wiring elements and to at least one of the plurality of further wiring elements, and wherein each of the conductive areas of the at least one electrically conductive layer structure is spaced by a distance from a respective conductive area connected to an adjacent wiring element, wherein said distance is at least 5% (preferably at least 10%) of a diameter of the wiring element (in particular of a wiring element of the wiring plane with the first and second rows), wherein an amount of further wiring elements connected to a respective conductive area which is connected to a wiring element of the first row is higher than an amount of the further wiring elements connected to the respective conductive area which is connected to a wiring element of the second row, and wherein an amount of further wiring elements connected to a larger conductive area is higher than an amount of further wiring elements connected to a smaller conductive area.

According to the invention, a method of manufacturing a component carrier is provided, wherein the method comprises providing a stack comprising at least two electrically insulating layer structures and at least one electrically conductive layer structure (preferably a plurality of electrically conductive layer structures), forming a plurality of wiring elements in one of the at least two electrically insulating layer structures, said plurality of wiring elements being arranged in a wiring plane to form a first row of equidistant wiring elements arranged along a straight direction within the wiring plane, and a second row of equidistant wiring elements arranged along the straight direction within the wiring plane, forming a plurality of further wiring elements in another of the at least two electrically insulating layer structures, forming the at least one electrically conductive layer structure so as to comprise several conductive areas being electrically insulated with respect to each other, each of said conductive areas being connected to at least one of the plurality of wiring elements and to at least one of the plurality of further wiring elements, and forming each of the conductive areas of the at least one electrically conductive layer structure so as to be spaced by a distance from a respective conductive area connected to an adjacent wiring element, wherein said distance is at least 5% (preferably at least 10%) of a diameter of the wiring element (in particular of a wiring element of the wiring plane with the first and second rows), wherein an amount of further wiring elements connected to a respective conductive area which is connected to a wiring element of the first row is higher than an amount of the further wiring elements connected to the respective conductive area which is connected to a wiring element of the second row, and wherein an amount of further wiring elements connected to a larger conductive area is higher than an amount of further wiring elements connected to a smaller conductive area.

In the context of the present application, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above mentioned types of component carriers.

In the context of the present application, the term "stack" may particularly denote a sequence of two or more layer structures formed on top of each other. For instance, layer structures of a layer stack may be connected by lamination, i.e. the application of heat and/or pressure. Preferably, the stacked layer structures may be arranged parallel to each other.

In the context of the present application, the term "layer structure" may particularly denote a continuous layer, a patterned layer, or a plurality of nonconsecutive islands within a common plane.

In the context of the present application, the term "wiring elements" may particularly denote electrically conductive elements forming part of a wiring or electric interconnection within a dielectric matrix of the stack. Wiring elements may be formed within an electrically insulating layer structure and as part of an electrically conductive layer structure. The wiring elements may comprise vertical through-connections for creating vertical electrical interconnections between different layer structures of the stack. The wiring elements may comprise electrically conductive through-connections extending through the thickness of the layer structure(s) and/or stack, preferably from one main surface to the opposed main surface of said layer structure(s) and/or stack, and/or along a perpendicular or inclined direction with respect to one of the main surfaces of said layer structure(s) and/or stack. Such connections may be vias, such as metallic laser vias, metallic mechanically drilled vias, sleeve shaped vias, full metal vias, metallic posts, or the like. Wiring elements may also comprise horizontal electrically conductive structures, such as traces and/or pads. Moreover, wiring elements may have straight and/or tapered shapes, e.g. cylindrical or frustoconical shapes.

In the context of the present application, the term "row of equidistant wiring elements" may denote a group of wiring elements arranged along a straight direction and having a constant mutual spacing between each pair of adjacent wiring elements of said row. In other words, the mutual spacing may be the same for each two neighboured wiring elements belonging to the group. For example, only the equidistant wiring elements of the row may be arranged along said straight direction. Alternatively, it is also possible that one or more further wiring elements are arranged between the equidistant wiring elements of the row along said straight direction. For example, a row of equidistant wiring elements may be a sequence of at least three, in particular of at least ten, wiring elements with the same mutual distance with respect to its neighbouring wiring element or elements of the group. A person skilled in the art will understand that, when forming equidistant wiring elements, technical tolerances (in particular manufacturing tolerances) may occur inevitably, which may lead to a very small deviation of an exactly identical distance between adjacent wiring elements of the row. However, when designing a component carrier for subsequent manufacture, equidistant wiring elements can be defined (for example in a design file) to have the same mutual target distance from each other. For example, actually manufactured equidistant wiring elements may have a mutual spacing or distance from each other which may deviate from an identical target distance by not more than a wiring element diameter. For example, actually manufactured equidistant wiring elements may have a mutual spacing or distance from each other which may deviate from an identical target distance by less than 5%, in particular by less than 2%. Due to technical tolerances, also dimensions (such as diameters) of equidistant wiring elements may show unavoidable variations, although - in an embodiment - equidistant wiring elements can be constructed (for example in a design file) to have the same dimensions (such as diameters). The length between two mutual wiring elements may be measured by measuring the distance between the centre of a first wiring element and the centre of a second wiring element (in nearest proximity along said straight direction).

In the context of the present application, the term "conductive area" may particularly denote a structure of electrically conductive material, in particular a metal such as copper, which is arranged to function as an electrically conductive connection between wiring elements of different wiring planes at different vertical levels of a component carrier stack. In particular, such conductive areas may be flat or planar structures. Conductive areas may be configured as land pads, which may also be denoted as lands. A respective conductive area may cover or surround a wiring element for increasing its extension or connection area in a horizontal plane for simplifying connection of a further wiring element arranged at another vertical level. For example, a conductive area may have an annular or circular shape. The thickness of a conductive area may be equal to the thickness of an electrically conductive layer structure. Additionally or alternatively, the thickness of a conductive area may be different from the thickness of an electrically conductive layer structure.

In the context of the present application, the term "wiring plane" may particularly denote a common plane on that the rows (i.e the first and the second rows) of the wiring elements are provided. The common plane may be defined from a planar view perpendicular to one main surface of a layer structure and/or stack. The common plane may be defined as a plane parallel to a main surface of a layer structure and/or stack, preferably the common plane corresponds to a main surface of a layer structure and/or stack.

In the context of the present application, the term "diameter of a wiring element" may particularly denote a constant diameter of the wiring element when embodied with vertical sidewalls, in particular as cylindrical structure (for instance in case of a metal filled mechanical through hole). Alternatively, in case of an irregular (non-constant) diameter, the term "diameter of the wiring element" may denote the smallest measure of the diameter of the wiring element, particularly from the direction perpendicular to the axis of the wiring element. When embodied as tapering structure (for instance in case of a metal filled laser via), said diameter may be the smallest diameter of the tapering wiring element, for instance having a frustoconical shape. When embodied as hollow structure (for example as a through hole in the stack with plated sidewalls and a remaining hollow core), the diameter of the wiring element may be its exterior diameter.

According to an exemplary embodiment of the invention, a stacked layer-type component carrier is provided which comprises wiring elements in a wiring plane forming rows of equidistant wiring elements arranged along a straight direction. In addition, further wiring elements are provided in another wiring plane. Furthermore, several mutually insulated conductive areas (such as land pads) may be provided each being connected with a wiring element in the wiring plane and a further wiring element in the other wiring plane, so that a respective conductive area may function as a wiring element interface. Advantageously, adjacent conductive areas connected to adjacent wiring elements may be mutually spaced by distance of at least 5% of a diameter of a respectively connected wiring element. Such a design may lead to a simple, reliable and compact interconnection of wiring elements in different wiring planes while simultaneously maintaining a sufficient safety distance between adjacent conductive areas. This may reliably prevent undesired electrical breakdown and disruptive discharge, as well as an unwanted short.

In the following, further exemplary embodiments of the component carrier and the method will be explained.

In an embodiment, each of the conductive areas of the at least one electrically conductive layer structure is spaced by a distance from a respective conductive area connected to an adjacent wiring element, wherein said distance is not more than 30% (preferably not more than 20%) of a diameter of the wiring element. This upper limit may ensure a compact design of the component carrier. Furthermore, this design rule may promote compliance with even demanding requirements concerning circuit elements current carrying capacity and the resulting current density (i.e. current carrying capacity per area), for instance of 0.5 A/mm² to 15 A/mm².

In an embodiment, the wiring elements of the second row are provided with an offset along the straight direction with respect to the wiring elements of the first row. In the context of the present application, the term "offset rows of wiring elements" may particularly denote rows of wiring elements being arranged with a spatial shift between, on the one hand, the equidistant wiring elements of the first row and, on the other hand, the equidistant wiring elements of the second row along a straight direction along which also the wiring elements of the first row and of the second row are arranged. More specifically, the equidistant wiring elements of the second row may be displaced as a whole along the straight direction with regard to the equidistant wiring elements of the first row. Due to said non-zero offset, the wiring elements of the first row may be out of alignment with respect to the wiring elements of the second row what concerns said straight direction. Apart from this, the wiring elements of the first row and the wiring elements of the second row may or may not be spaced or offset from each other along a further direction perpendicular to said straight direction. Both said directions (i.e. the straight direction and the further direction) may be within a common wiring plane. Arranging the rows of wiring elements with mutual offset may promote compliance with target requirements, such as one or more target current-related values to be achieved, and/or a density of wiring elements within a specific surface, without the risk of a disruptive discharge between adjacent wiring elements.

In an alternative embodiment, it may be possible to arrange the wiring elements of the second row without an offset along the straight direction with respect to the wiring elements of the first row.

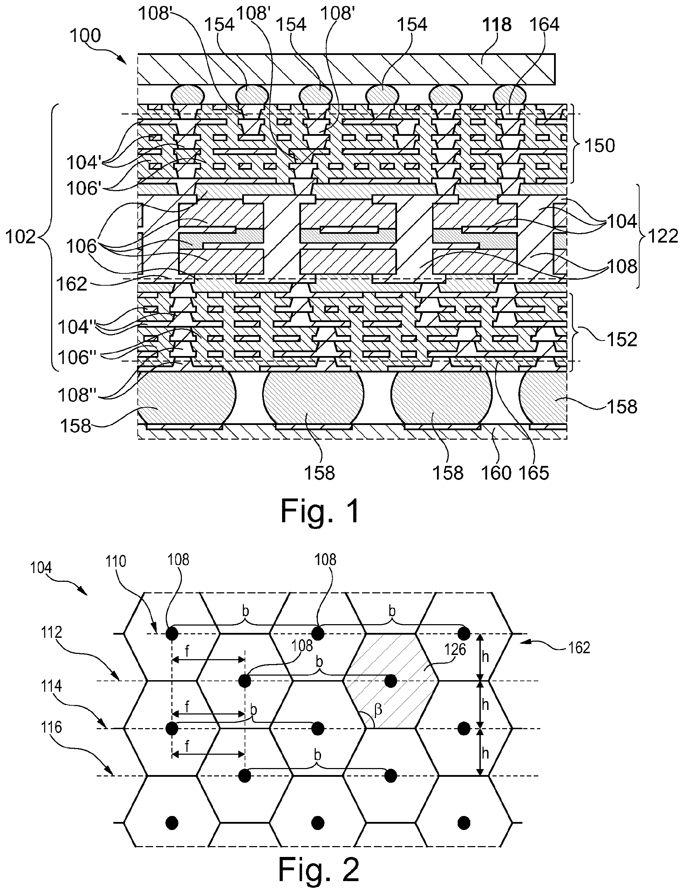

In an embodiment, an offset value of the offset of the equidistant wiring elements of the second row with respect to the equidistant wiring elements of the first row along the straight direction is 1/2 of a mutual spacing between adjacent equidistant wiring elements of the first row (see for example Figure 2). What concerns the straight direction, the described design rule may correspond to wiring elements of the second row being arranged in the middle between two respective wiring elements of the first row. In particular, such an embodiment may relate to a configuration in which the first row and the second row are also vertically displaced, i.e. are displaced also along a direction perpendicular to the straight direction. This may ensure a reliable electric separation between different wiring elements of different rows.

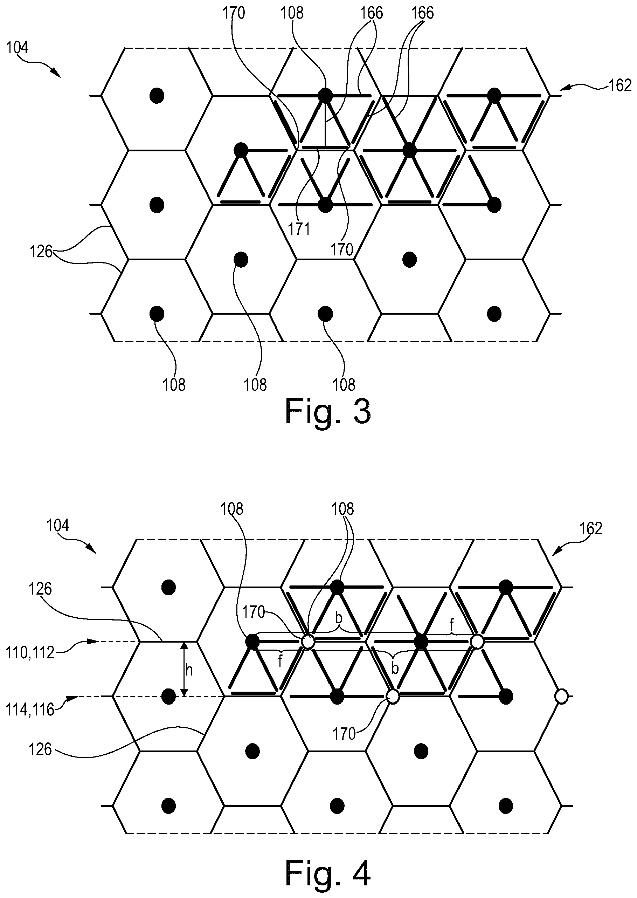

In another embodiment, an offset value of the offset of the equidistant wiring elements of the second row with respect to the equidistant wiring elements of the first row along the straight direction is 1/3 of a mutual spacing between adjacent equidistant wiring elements of the first row. (see for example Figure 4). What concerns the straight direction, the described design rule may correspond to wiring elements of the second row being arranged closer to one than to another of two respective wiring elements of the first row, wherein a distance ratio may be 2:1. In particular, such an embodiment may relate to a configuration in which the first row and the second row are not vertically displaced, i.e. are all arranged along the straight direction without being spaced perpendicular thereto. Thus, this design rule may correspond to a configuration in which the equidistant wiring elements of the first row and of the second row are at the same level within the wiring plane. In other words, the first row and the second row may extend along the same straight direction without a mutual displacement perpendicular to said common straight direction. This design rule may allow to arrange a large number of wiring elements with small space consumption. Alternatively, the non-displacement along the vertical direction between the first row and the second row can be provided in the embodiment in which the offset value corresponds to 1/2 of a mutual spacing between adjacent equidistant wiring elements of the first row and/or the displacement along the vertical direction between the first row and the second row can be provided in the embodiment in which the offset value corresponds to 1/3 of a mutual spacing between adjacent equidistant wiring elements of the first row.

In an embodiment, at least part of the wiring elements is arranged at centers of hexagonal virtual cells of the wiring plane, each of said hexagonal virtual cells being adjacent one to the other sharing a respective side of a respective hexagon with a respective adjacent hexagon. Hence, a plane of wiring elements of a component carrier may be configured in accordance with Voronoi cells with hexagonal outline. A wiring plane or a region of interest thereof may thus be virtually divided into a plurality of hexagonal virtual cells which may be connected directly with each other along respective sides. For instance, the wiring elements may be arranged in centres of such hexagonal virtual cells, and/or at corners thereof. Such a regular pattern of virtual hexagonal virtual cells may translate into a wiring pattern of high symmetry which may lead to a well-defined electric distribution system. Hence, no free space and no gaps may remain between the adjacent hexagonal virtual cells. As an alternative to hexagonal virtual cells, other embodiments may also implement cells with another outline, for instance regular triangular cells or rectangular (preferably square) cells. Subdividing a wiring plane into Voronoi cells has turned out as a powerful tool for achieving compliance with electric target requirements of a component carrier under construction, such as target current-related values, while simultaneously ensuring electric safety.

In an embodiment, the wiring elements are arranged so that a mutual distance between adjacent equidistant wiring elements of the first row equals to a mutual distance between adjacent equidistant wiring elements of the second row. In other words, a spacing of adjacent ones of the equidistant wiring elements of the first row may be the same as a mutual spacing between adjacent ones of the equidistant wiring elements of the second row. This may provide a high degree of symmetry and may therefore promote a high current carrying capacity in combination with high electric reliability.

In an embodiment, the plurality of further wiring elements are arranged in a further wiring plane parallel to the wiring plane and in accordance with a corresponding pattern as but another density of wiring elements than the first row and the second row of wiring elements. For instance, the arrangement of the wiring elements described above may relate to a core with metallized through-holes (i.e. metal filled mechanically drilled through-holes), whereas the further wiring elements may relate to a build-up layer on top or bottom of such a core and may comprise metalized laser vias (or vice versa). For example, a wiring plane with wiring elements comprising metalized laser vias may have smaller dimensioned wiring elements and a higher number of wiring elements per area or volume than a core having larger metallized through-holes with a smaller number of wiring elements per area or volume. While the density of wiring elements may be different for said different wiring planes, the regularity of the pattern of wiring elements in such different wiring planes may be correspondingly. It is possible that the wiring elements and the further wiring elements are electrically coupled with each other, partially or entirely. For example, a plurality of further wiring elements (for instance metal filled laser vias) may be electrically coupled with one wiring element (for example a metal filled mechanically drilled hole) by connecting said further wiring elements to a respective conductive area, such as a land pad, formed around said wiring element. In particular, at least one of the plurality of further wiring elements may be connected to a (in particular main) surface of the conductive area and at least one of the wiring elements may be connected to another opposed (in particular main) surface of the conductive area.

In an embodiment, the wiring elements and the further wiring elements are arranged in a shadow area of a component being surface mounted on the stack of the component carrier. A shadow area of a surface mounted component may correspond to a spatial region in the stack in which electric connections for the component shall be arranged. For instance, the shadow area may taper from an interior of the stack towards the surface mounted component. Such a tapering may reflect the fact that an integration density can be larger closer to the surface mounted component compared to a stack portion further remote from the surface mounted component. Such a tapering may correspond to a redistribution function of the wiring elements and the further wiring elements.

A shadow area of the above-mentioned surface mounted component may be a projection of the surface mounted component onto wiring planes of the stack in which the wiring elements and the further wiring elements are arranged. In particular, the region directly below the component may be most critical in terms of an electric interconnection. For this purpose, specifically said shadow area beneath a surface mounted component (for instance having a very high number of I/O pads) may be an advantageous region for arranging the wiring elements and the further wiring elements in the described manner. The shadow area may extend into the stack vertically, or in such a way that it tapers towards the surface mounted component. The latter measure may reflect a redistribution structure arrangement beneath the surface mounted component so as to achieve compliance with a larger pitch of a mounting base beneath the stack (for example a mounting base embodied as printed circuit board).

Hence, the component carrier may comprise at least one surface mounted component, such as a semiconductor chip, in particular a power semiconductor chip or a processor chip. It is also possible that a plurality of electronic components are surface mounted on the stack. Additionally or alternatively, one or more electronic components may be embedded in the stack, and may also be served by the wiring elements concerning their electric interconnection.

In an embodiment, the wiring elements are arranged in a core of the component carrier. Furthermore, it may be possible that the further wiring elements are arranged in a build-up on such a core of the component carrier. Thus, a component carrier may have a stack with a central core of fully cured dielectric material having a high thickness and having metalized holes extending therethrough. For example, a core may have a thickness in a range from 500 µm to 2 mm. A build-up may be formed on one or both of opposing main surfaces of such a core and may have a higher density of wiring elements, which may be embodied as metal filled laser vias. The core may have a key function in terms of distribution of power and signals and may therefore be designed in accordance with the equidistant wiring element rows, as described above. However, an elegant interconnection between the wiring elements of the core and the further wiring elements of the build-up may be accomplished by the above described design of the conductive areas and its interconnection with the wiring elements and the further wiring elements.

In an embodiment, the wiring elements are mechanical drill holes filled at least partially with a metal, and the further wiring elements are laser drill holes filled at least partially with a metal. In accordance with this configuration, the wiring elements may have straight side walls, for instance may have a circular cylindrical shape or a hollow cylindrical shape. Correspondingly, the further wiring elements may have tapering sidewalls, for example may have a frustoconical shape being either filled completely with metal or comprising only a sleeve-type hollow metal filling.

In an embodiment, at least part of the conductive areas are land pads. Land pads may be flat structures surrounding a connected wiring element for increasing a contact surface for a further wiring element to be connected therewith.

In an embodiment, at least part of the conductive areas have a planar annular shape surrounding a respective one of the wiring elements. Such annular or ring-like structures may be formed around a flange face of a wiring element and in direct contact with said wiring element.

In an embodiment, at least part of the conductive areas are circular (in particular have a circular outline) and are aligned coaxially with an axis of a respective wiring element. Also in such a configuration of a conductive area, a direct physical contact may be established between a continuous conductive area and the flange face of the wiring element. The described embodiment may lead to a high degree of symmetry and thus electric reliability. In an example, the wiring element or further wiring element may be in direct physical contact with one conductive area. In another example, the wiring element or further wiring element may be in direct physical contact with two conductive areas, each conductive area being located at an opposed extremity of the (in particular further) wiring element, respectively.

In an embodiment, adjacent wiring elements of said electrically insulating layer structure have different cross-sectional areas. Thus, the diameter and therefore cross-sectional area of wiring elements may be used as an individually adjustable design parameter for fine-tuning the electric properties of the component carrier. This may increase the flexibility of design.

Correspondingly, adjacent further wiring elements of said other electrically insulating layer structure may have different cross-sectional areas. Thus, also in the further wiring plane, the diameter and consequently cross-sectional area of different further wiring elements may be used as a design parameter for individual adaptation for adjusting the electric properties of the component carrier in a local way. This may allow to consider local particularities in one or more build-up layers.

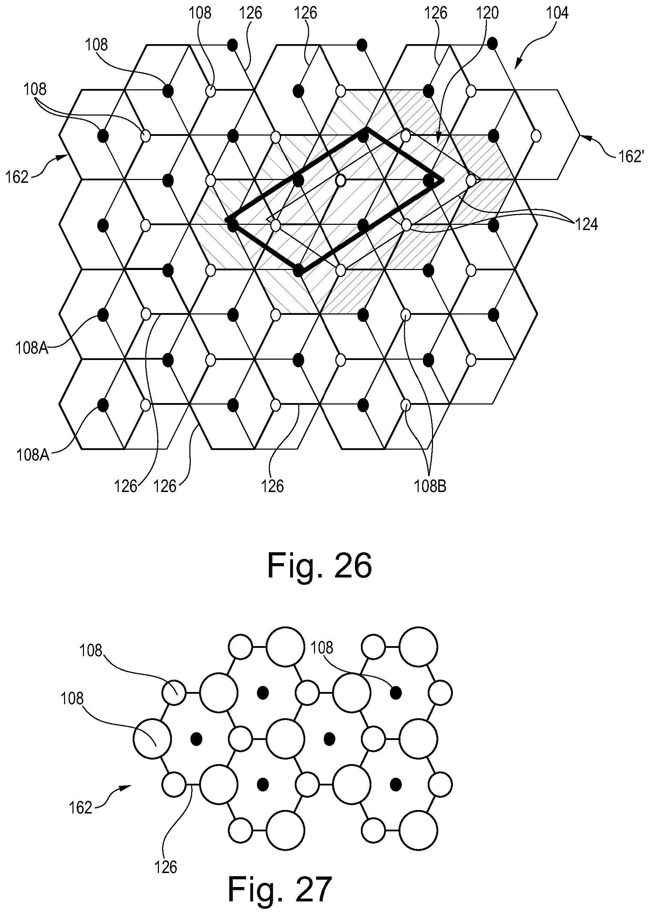

In another embodiment, adjacent wiring elements of said electrically insulating layer structure have the same cross-sectional areas. In such an embodiment, all wiring elements of the common wiring plane may have the same diameter and consequently cross-sectional area. This may lead to a high symmetry in the wiring plane and a simple design. In yet another embodiment, adjacent wiring elements of said electrically insulating layer structure have different cross-sectional areas (see for example Figure 27). This may allow to achieve a specific targeted delivery of currents or mix between power delivery network and signal management.

Accordingly, adjacent further wiring elements of said other electrically insulating layer structure may have the same cross-sectional areas. However, the cross-sectional area of the further wiring elements may be different from the cross-sectional area of the wiring elements. In this way, a core can be designed in a different way than one or more build-ups.

In an embodiment, further wiring elements connected to the respective conductive area have the same cross-sectional areas as those of the further wiring elements connected to the conductive area which is connected to the adjacent wiring element. Alternatively, further wiring elements connected to the respective conductive area have different cross-sectional areas than those of the further wiring elements connected to the conductive area which is connected to the adjacent wiring element.

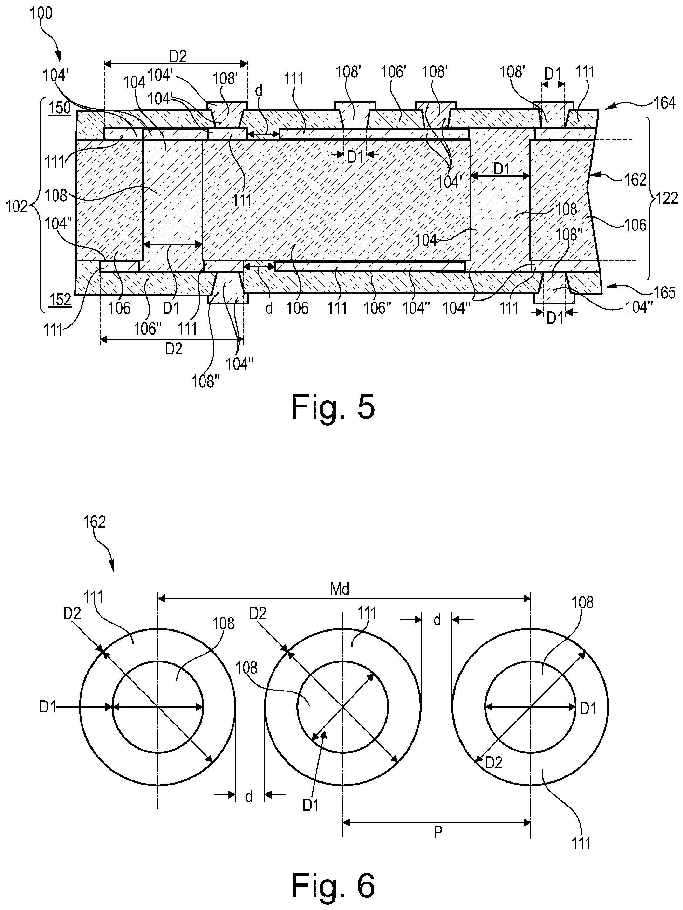

In an embodiment, at least one of said conductive areas is electrically connected with at least two of said further wiring elements. In such a preferred embodiment, at least two and preferably at least three of the further wiring elements assigned to the further wiring plane are all connected with direct physical contact to the same conductive area, in particular to the same annular land pad of a wiring element of the wiring plane. This may result in a highly compact design and may allow to realize even sophisticated electronic connection architectures. A corresponding embodiment is shown in Figure 5.

In an embodiment, at least one of said conductive areas is connected with only one of the wiring elements. Hence, a respective conductive area may be assigned to exactly one wiring element of the central wiring plane.

According to the invention, an amount of further wiring elements connected to a respective conductive area which is connected to a wiring element of the first row is higher than an amount of the further wiring elements connected to the respective conductive area which is connected to a wiring element of the second row. Thus, the different rows of equidistant wiring elements may be implemented with a different configuration of connected conductive areas and further wiring elements. This may open the design for further degrees of freedom and may therefore increase the flexibility of design.

According to the invention, an amount of further wiring elements connected to a larger conductive area is higher than an amount of further wiring elements connected to a smaller conductive area. Thus, when a larger conductive area is present, it may be used for connecting more further wiring elements than connected with a smaller conductive area.

In an embodiment, an amount of further wiring elements connected to a respective conductive area which is connected to a wiring element of the first row is the same as an amount of further wiring elements connected to a respective conductive area which is connected to a wiring element of the second row. In particular, said conductive areas may have the same area values. In such a configuration, the rows of equidistant wiring elements may be connected in the same way to respective further wiring elements via respective conductive areas.

In an embodiment, one of the conductive areas of one row (in particular the first row or the second row) is arranged with a distance from another one of the conductive areas connected to a closest adjacent wiring element of the other row (in particular the second row or the first row) of at least 5% of a diameter of the wiring element. Hence, a 5% design rule may apply to the different rows of equidistant wiring elements.

In an embodiment, one of the conductive areas of one row (in particular the first row or the second row) is arranged with a distance from another one of the conductive areas connected to an adjacent wiring element of the same row of at least 5% of a diameter of the wiring element. Thus, a 5% design rule may be realized for different wiring elements and conductive areas of the same row of equidistant wiring elements.

In an embodiment, the further wiring elements have a smaller dimension, in particular a smaller diameter, compared with a larger dimension, in particular a larger diameter, of the wiring elements. Different regions of the stack may be provided with a different density of wiring elements, i.e. a different number of wiring elements per volume or area. For instance, such a density may be smaller in a core than in a build-up. In a region with higher integration density, in particular in a build-up on a core, the individual further wiring elements may have a smaller dimension than the wiring elements in a region with lower integration density, in particular in a core. For example, the smaller dimensioned further wiring elements may be formed as metal filled laser vias, whereas the larger dimensioned wiring elements may be formed as metal filled mechanically drilled holes.

In an embodiment, a sum of the cross-sectional areas of the further wiring elements connected to the same conductive area is equal to or larger than a cross-sectional area of a wiring element connected to the same conductive area. Thus, even when individual further wiring elements of the further wiring plane may have a smaller cross-sectional area than a connected wiring element of the wiring plane, a higher integration density in the further wiring plane than in the wiring plane may lead to the same or even a higher overall metal cross-sectional area in the further wiring plane in comparison with the wiring plane.

In an embodiment, different regions of the component carrier have different distributions of wiring elements. Thus, the distribution of the wiring elements in the wiring plane may be inhomogeneous. This may allow to take into account local particularities or different needs concerning wiring in different regions of the stack. For instance, a density of wiring elements may be larger in a die shadow area compared with other regions of the stack. This may reduce the manufacturing effort while fully complying with functional demands of a component carrier under design.

In an embodiment, the component carrier comprises a plurality of still other wiring elements provided in still another of the at least two electrically insulating layer structures on an opposing side of said electrically insulating layer structure in relation to said other electrically insulating layer structure. Some conductive areas may be connected to at least one of the plurality of still other wiring elements, wherein each of said some conductive areas may be spaced by a distance from a respective conductive area connected to an adjacent still other wiring element, and wherein said distance may be at least 5% of a diameter of the still other wiring element. Hence, the wiring plane with the wiring elements may be connected at one side with the above described further wiring plane including the further wiring elements via the above mentioned conductive areas. In addition, said wiring plane may be connected at its opposing other side with still other wiring elements of still another wiring plane via conductive areas. To put it shortly, the interconnection of the still other wiring elements with the wiring elements via still other conductive areas may be realized in a corresponding way as for the further wiring elements. Thus, a symmetrical buildup may be obtained. The wiring elements may be assigned to a core, whereas the further wiring elements and the still other wiring elements may form part of build-ups on both opposing main surfaces of the core.

In a corresponding way, it may also be possible that each of said some conductive areas is spaced by a distance from a respective conductive area connected to an adjacent wiring element. Said distance may be at least 5% of a diameter of the wiring element.

In an embodiment, the wiring elements function for distributing electric power in the component carrier. This may be particularly advantageous for high performance computing applications, artificial intelligence applications, processor applications, and the like requiring a large amount of electric energy during operation.

In an embodiment, some of the wiring elements function for distributing signals in the component carrier. The arrangement of wiring elements in a wiring plane in rows with equidistant wiring elements may also support a reliable signal transport.

In an embodiment, some of the wiring elements function for providing a reference potential, in particular a ground potential in the component carrier. Also a ground potential or the like may be required for operating a surface mounted component. Yet other of the wiring elements may function for distributing heat.

In an embodiment, some of the wiring elements functioning for distributing electric power or signals or for providing a reference potential (such as a ground potential) are those provided on the first row or on the second row or on a third row. It is also possible that some other of the wiring elements with a different function are provided in another one of the first row or the second row or the third row. For example, each of the rows may have a separate function. Wiring elements of the first row may contribute to a first electric function, whereas wiring elements of a second row may contribute to another electric function. If wiring elements of a third row are present, they may provide a third electric function, and so on.

In an embodiment, the wiring elements are arranged in accordance with Voronoi cells within the wiring plane. In mathematics, a Voronoi cell may denote a region or partition of a plane (presently a wiring plane) including all points of the plane closer to a specific object (in this case a mechanically drilled through hole) than to any other object in the plane. A set of Voronoi cells defines a Voronoi diagram. Voronoi cells may provide an excellent basis for determining an arrangement of wiring elements of a wiring plane of a stack. They have a high degree of symmetry and may be free of gaps in between. The high symmetry of a corresponding arrangement of wiring elements may translate into well-defined and highly appropriate electric properties.

In an embodiment, the Voronoi cells are hexagonal virtual cells, in particular each delimited by a regular hexagon. However, the Voronoi cells may also be triangular cells, rectangular cells, or other polygonal Voronoi cells.

In an embodiment, the method comprises arranging the wiring elements for adjusting a number of wiring elements in the wiring plane complying with a predefined specification. A specification may define attributes concerning the electric functionality of a wiring plane or of the component carrier to be designed as a whole. The wiring elements may then be arranged in the first row, the second row, and optionally in further rows so as to comply with the specification. Such a process may be carried out manually, or preferably automatically (for instance by executing a fitting routine and/or by applying artificial intelligence).

In an embodiment, the method comprises arranging the wiring elements for adjusting a current carrying capability of the wiring elements in the wiring plane. When designing the arrangement of the wiring elements, the achievement of a predefined current density (i.e. conducted current per cross-sectional metal area) of the wiring elements, for instance of values from 0.5 A/mm² to 15 A/mm², may be considered as a boundary condition which shall be fulfilled by the arrangement of the wiring elements to be designed.

In an embodiment, the method comprises determining at least one of a spatial distribution, a land diameter, a drill diameter and/or a functional grouping of the wiring elements complying with a predefined specification. Other parameters may be considered for the design of the wiring elements as well.

In an embodiment, the method comprises arranging the wiring elements in accordance with hexagonal Voronoi cells around respective wiring elements and by combining sets of wiring elements of neighbouring hexagonal Voronoi cells to four-sided blocks, in particular to parallelogram-type blocks (see for example Figure 26). Voronoi cells may provide a virtual distribution of directly connected cells without gaps in between and may provide a proper basis for a symmetric arrangement of wiring elements. The definition of four-sided blocks, in particular parallelogram-type blocks, may further refine the designed arrangement of wiring elements.

In a further embodiment, the area of conductive areas (such as lands) may be bigger than 50%, in particular bigger than 70%, of the area of the entire wiring plane, at least in a portion of the wiring plane. In yet another embodiment, further wiring elements may be in contact in the periphery portion of the conductive areas. Additionally or alternatively, the further wiring elements may be in contact in a central portion of the conductive areas.

In an embodiment, the component carrier comprises a stack which comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

In an embodiment, the component carrier related body is a laminate-type component carrier. In such an embodiment, the component carrier is a compound of multiple layer structures which are stacked and connected together by applying a pressing force and/or heat.

The aspects defined above and further aspects of the invention are apparent from the examples of embodiment to be described hereinafter and are explained with reference to these examples of embodiment.
Figure 1 illustrates a partial cross-sectional view of a component carrier according to an exemplary embodiment suitable to be implemented with the present invention.
Figure 2 illustrates a plan view of a wiring plane of the component carrier according to Figure 1.
Figure 3 illustrates a plan view of a wiring plane of a component carrier according to an exemplary embodiment suitable to be implemented with the present invention.
Figure 4 illustrates a plan view of a wiring plane of a component carrier according to an exemplary embodiment suitable to be implemented with the present invention.
Figure 5 illustrates a cross-sectional view of part of a component carrier according to an exemplary embodiment of the invention.
Figure 6 illustrates a plan view of part of a wiring plane of the component carrier according to Figure 5.
Figure 7 illustrates constituents of a computer-based system for defining a distribution of wiring elements for a component carrier to be designed, and illustrates a table with parameters defining structure and performance of a component carrier according to an exemplary embodiment suitable to be implemented with the present invention.
Figure 8 illustrates a plan view of wiring elements of a detail of a wiring plane of a component carrier according to an exemplary embodiment suitable to be implemented with the present invention.
Figure 9 illustrates a plan view of part of wiring planes of a component carrier according to an exemplary embodiment suitable to be implemented with the present invention illustrating mechanically drilled through holes of a core and laser drilled through holes of a build-up.
Figure 10 illustrates a plan view of a wiring plane of a component carrier according to an exemplary embodiment suitable to be implemented with the present invention.
Figure 11 illustrates a cross-sectional view of a component carrier and a plan view of a wiring plane of the component carrier according to an exemplary embodiment suitable to be implemented with the present invention.
Figure 12 illustrates a plan view of another wiring plane of the component carrier according to Figure 11.
Figure 13 illustrates a plan view of an overlay of the wiring planes of Figure 11 and Figure 12.
Figure 14 illustrates a plan view of part of a wiring plane of a component carrier according to an exemplary embodiment of the invention.
Figure 15 illustrates a cross-sectional view of part of a component carrier according to an embodiment not part of the present invention.
Figure 16 illustrates a plan view of part of a wiring plane of a component carrier according to an exemplary embodiment not part of present the invention.
Figure 17 illustrates a plan view of different wiring planes of a component carrier according to an exemplary embodiment suitable to be implemented with the present invention.
Figure 18 illustrates a similar view as Figure 17 indicating additional conductive areas around wiring elements.
Figure 19 illustrates a detail of Figure 18.
Figure 20 illustrates a plan view of a wiring plane of a component carrier according to an exemplary embodiment suitable to be implemented with the present invention to which an additional wiring element is added.
Figure 21 illustrates a plan view of a conventional wiring plane of a component carrier suitable to be implemented with the present invention.
Figure 22 illustrates a plan view of different wiring planes of a component carrier according to an exemplary embodiment suitable to be implemented with the present invention.
Figure 23 illustrates a plan view of a wiring plane of a component carrier according to an exemplary embodiment suitable to be implemented with the present invention.
Figure 24 illustrates a plan view of a wiring plane of a component carrier according to an exemplary embodiment suitable to be implemented with the present invention.
Figure 25 illustrates a plan view of a wiring plane of a component carrier according to an exemplary embodiment suitable to be implemented with the present invention.
Figure 26 illustrates a plan view of different wiring planes of a component carrier according to an exemplary embodiment suitable to be implemented with the present invention.
Figure 27 illustrates a plan view of a wiring plane of a component carrier according to an exemplary embodiment suitable to be implemented with the present invention.

The illustrations in the drawings are schematic. In different drawings, similar or identical elements are provided with the same reference signs.

Before referring to the drawings, exemplary embodiments will be described in further detail, some basic considerations will be summarized based on which exemplary embodiments of the invention have been developed.

According to an exemplary embodiment of the invention, a (preferably laminate-type) component carrier is provided having an array of wiring elements in a wiring plane. The latter may form a first row of equidistant wiring elements arranged along a straight direction within the wiring plane, and a second row of equidistant wiring elements arranged along the straight direction within the wiring plane. In addition, further wiring elements may be provided in another wiring plane. Furthermore, at least one electrically conductive layer structure (preferably a plurality of electrically conductive layer structures) of a stack of the component carrier may comprise several conductive areas (descriptively speaking, said conductive areas may be land pads of the wiring elements) which may be electrically insulated from each other. Each conductive area may be connected to a respective one of the wiring elements and to a respective one of the further wiring elements. Moreover, each of the conductive areas may extend at a distance from (i.e. may be spaced with respect to) the conductive area connected to the adjacent wiring element of at least 5% of the value of the diameter of the wiring element. In an example, said distance between adjacent conductive areas may be 30 µm, whereas a diameter of the wiring element connected to the conductive area may be 400 µm (for instance when the wiring element is a metal filled mechanically drilled through holes in a core). Thus, the mentioned example corresponds to a ratio of 30 µm/400 µm=7.5%. A minimum distance of 5% may ensure a reliable electric decoupling of adjacent conductive areas and consequently of adjacent wiring elements. This may efficiently suppress undesired phenomena such as an electrical short, electrical breakdown or disruptive discharge in an interior of the component carrier.

In a preferred embodiment, an axis of a respective conductive area may be coaxial with the axis of the respective wiring element. It may further be preferred that the respective conductive area has a diameter so that the distance of the periphery of the conductive area and the periphery of the conductive area connected to the adjacent wiring element is at least 5% (example: 30 µm/400 µm=7.5%) of the value of the diameter of the respective wiring element.

In one embodiment, the conductive areas of the respective adjacent wiring elements have different area values. Alternatively, the conductive areas of the respective adjacent wirings may have same area values.

For example, a plurality of further wiring elements is provided in a respective conductive area. In other words, one conductive area may be in direct physical contact with two or more further wiring elements. For example, the latter may be spatially distributed along a circumferential ring, constituting a conductive area, surrounding a wiring element.

According to the invention, the amount of further wiring elements connected to the respective conductive area connected to a wiring element of the first row is higher than the amount of the further wiring elements connected to the respective conductive area connected to a wiring element of the second row.

Moreover, an amount of further wiring elements connected to a larger conductive area (i.e. a conductive area having a larger connection surface) is higher than an amount of further wiring elements connected to a smaller conductive area (i.e. a conductive area having a smaller connection surface).

Additionally, an amount of further wiring elements connected to the respective conductive area connected to a wiring element of the first row could be the same as the amount of the further wiring elements connected to the respective conductive area connected to a wiring element of the second row. In particular, the conductive areas of the respective adjacent wiring elements may have same area values.

Preferably, the second row of the wiring elements may be offset along the straight direction with respect to the wiring elements of the first row. In one embodiment, the offset of the equidistant wiring elements of the second row with respect to the equidistant wiring elements of the first row along the straight direction is 1/2 of a mutual spacing between adjacent equidistant wiring elements of the first row. In other embodiments, the offset of the equidistant wiring elements of the second row with respect to the equidistant wiring elements of the first row along the straight direction is 1/3 of a mutual spacing between adjacent equidistant wiring elements of the first row.

In an embodiment, the conductive area connected with a wiring element extends with a distance from the conductive area connected to the closest adjacent wiring element of the other row of at least 5% (for instance at least 7.5%) of the value of the diameter of the wiring element. Additionally or alternatively, the conductive area connected with a wiring element extends with a distance from the conductive area connected to the adjacent wiring element of the same row of at least 5% (for example at least 7.5%) of the value of the diameter of the wiring element.

Preferably, the further wiring elements have a smaller dimension (in particular a smaller diameter) with respect to a dimension (in particular diameter) of the wiring elements.

A summation of the cross-sectional metal areas of the further wiring elements connected to the same conductive area may be equal to or greater than the cross-sectional metal area of the respective wiring element.

Preferably, the further wiring elements have the same pattern as the pattern of the wiring elements, but descaled.

In an embodiment, different distribution areas may be provided on the component carrier.

With the above mentioned approach, it may be possible to design for example an HPC (high-performance computing) substrate core. Power feeding of a component carrier may be defined by the design of the wiring elements of the respective wiring plane.

**Figure 1** illustrates a partial cross-sectional view of a component carrier 100 suitable to be implemented with the present invention. **Figure 2** illustrates a plan view of a wiring plane 162 of the component carrier 100 according to Figure 1.

Component carrier 100 may be an integrated circuit (IC) substrate or a printed circuit board (PCB). The component carrier 100 may comprise a laminated layer stack 102 comprising, in a core 122 (which may be, for example, a multilayer core), one or more electrically conductive layer structures 104 and one or more electrically insulating layer structures 106. For example, the one or more electrically conductive layer structures 104 may comprise patterned metal layers (such as patterned copper foils or patterned deposited copper layers) and vertical through connections, for example copper filled vias, which may be created by drilling and plating. The one or more electrically insulating layer structures 106 may comprise a respective resin (such as a respective epoxy resin), preferably comprising reinforcing particles therein (for instance glass fibers or glass spheres). For example, the one or more electrically insulating layer structures 106 may be made of FR4. The one or more electrically insulating layer structures 106 may also comprise resin layers being free of glass (in particular glass fibers).

As shown, a plurality of through-holes are formed in central core 122 of stack 102, for example by mechanically drilling. The through-holes in the core 122 may be filled, partially or entirely, with electrically conductive material, such as copper, for example by plating. Inside of the central electrically insulating layer structure 106, a plurality of wiring elements 108, forming part of the central electrically conductive layer structure 104, are provided.

As shown in Figure 1 as well, an upper build-up 150 and a lower build-up 152 are formed on top and on the bottom of the core 122, respectively. The bottom sided build-up 152 can be constructed in a similar way as the top-sided build-up 150.

Upper build-up 150 comprises a plurality of further electrically conductive layer structures 104' and electrically insulating layer structures 106'. Inside of the further electrically insulating layer structures 106', a plurality of further wiring elements 108', forming part of the further electrically conductive layer structures 104', are provided.

Correspondingly, the lower build-up 152 comprises a plurality of further electrically conductive layer structures 104" and electrically insulating layer structures 106". Inside of the further electrically insulating layer structures 106", a plurality of further wiring elements 108", forming part of the further electrically conductive layer structures 104", are provided.

More specifically, a plurality of metal filled laser vias are provided in each of the build-ups 150, 152, forming said further wiring elements 108', 108". The further wiring elements 108', 108" have a higher density (i.e. a larger number of wiring elements per area or volume) and smaller dimensions than the metal filled mechanically drilled through-holes extending through the core 122 and forming the wiring elements 108. Preferably, the wiring elements 108 have a cylindrical shape and the further wiring elements 108' and 108" have frustoconical shape.

On top of the upper build-up 150 and thus on an upper main surface of stack 102, a component 118 is surface mounted by an attachment technology such as soldering, thermocompression bonding, hybrid bonding, wire bonding, gluing or other metal to metal interdiffusion techniques. For example, component 118 is a semiconductor chip or a semiconductor package, for instance comprising at least one power semiconductor chip, a microprocessor, a central processing unit, a graphical processing unit, an artificial intelligence chip and/or another electronic component having a high electronic performance. The surface mounted component 118 is connected with the stack 102 by solder structures 154. It is also possible that a plurality of surface mounted components 118 are mounted on the stack 102.

At the bottom of the bottom-sided build-up 152, the stack 102 is mounted by further solder structures 158 on a mounting base 160, such as a printed circuit board (PCB), or mounted through the use of Land Grid Array pads into a socket, which is hosted for example by the PCB. A dimension in at least one direction of the further solder structures 158 can be bigger than a corresponding dimension of at least one direction of the solder structures 154.

Electric power and electric signals may be guided through the core 122 and the build-ups 150, 152 and therefore between the mounting base 160 and the surface mounted component 118. Electricity transported through the stack 102 and therefore through the core 122 may include electric power and/or electric signals. Furthermore, it may be possible to provide at least one electric reference potential (for example a ground potential) at one or more wiring elements 108 extending through the core 122.

As can be taken from the above description, the electric interconnection and the supply of electricity of component carrier 100 can be very challenging, in particular when a high current density (of for instance of values from 0.5 A/mm² to 15 A/mm²) and/or a high number of I/O connections of the surface mounted component 118 (for instance at least 10 or even at least 50 I/O connections) are required or desired. In order to meet these challenging demands concerning electric performance of the component carrier 100, wiring elements 108, 108', 108" in any of the electrically insulating layer structures 106, 106', 106" may be modelled and designed in a way as described below referring to Figure 2 and the subsequent figures. To put it shortly, a respective planar wiring layer may be defined, in particular wiring plane 162 extending through core 122. Additionally or alternatively, at least one other wiring plane may be designed, for instance a wiring plane 164 in upper build-up 150 and/or a corresponding wiring plane 165 in lower build-up 152.

In the following, it will be described on the example of wiring plane 162 as so how its wiring elements 108 can be designed according to an exemplary embodiment of the invention. This will be explained for wiring plane 162 of core 122, wherein the wiring plane 164 in upper build-up 150 and/or the wiring plane 165 in lower build-up 152 may be designed accordingly.

Now referring to Figure 2 showing a cross-section of Figure 1 through wiring plane 162, the corresponding electrically conductive layer structure 104 comprises a plurality of wiring elements 108. Said wiring elements 108 are arranged in wiring plane 162 and embedded in a dielectric matrix provided by the corresponding electrically insulating layer structure 106.

As shown in Figure 2, a first group of wiring elements 108 are arranged along a first row 110 of equidistant wiring elements 108 arranged along a straight direction (a horizontal direction according to Figure 2) within the wiring plane 162. More specifically, adjacent equidistant wiring elements 108 of the first row 110 all have same mutual distance, b, from each other. As shown as well in Figure 2, a second group of wiring elements 108 are arranged along a second row 112 of equidistant wiring elements 108 which are arranged along the same straight direction (the mentioned horizontal direction according to Figure 2) within the wiring plane 162 as the wiring elements 108 of the first row 110. More specifically, adjacent equidistant wiring elements 108 of the second row 112 all have to same mutual distance, b, from each other. Hence, the distance or spacing, b, may be the same for the first row 110 and for the second row 112. Thus, a mutual distance, b, between adjacent equidistant wiring elements 108 of the first row 110 equals to a mutual distance, b, between adjacent equidistant wiring elements 108 of the second row 112.

However, the second row 112 of equidistant wiring elements 108 is offset along the straight direction with respect to the wiring elements 108 of the first row 110 by an offset value, f. Descriptively speaking, if the wiring elements 108 of the second row 112 would be shifted along the horizontal straight direction by the offset value, f, said wiring elements 108 would be in alignment with the sequence of the wiring elements 108 of the first row 110. Furthermore, the offset value, f, of the equidistant wiring elements 108 of the second row 112 with respect to the equidistant wiring elements 108 of the first row 110 along the straight direction is 1/2 of a mutual spacing, b, between adjacent equidistant wiring elements 108 of the first row 110 or of the second row 112.

Furthermore, the second row 112 is spaced with respect to the first row 110 along a further straight direction perpendicular to the horizontal straight direction by a measure, h. In Figure 2, said further straight direction extends vertically. In other words, the second row 112 may be aligned parallel to the first row 110.

In addition to the wiring elements 108 of the first row 110 and of the second row 112, the wiring plane 162 of Figure 2 comprises a third row 114 next to the second row 112 and having an arrangement of wiring elements 108 as the first row 110. Furthermore, a fourth row 116 is arranged next to the third row 114 and has an arrangement of wiring elements 108 as the second row 112. Thus, a highly symmetric arrangement of wiring elements 108 is provided in the wiring plane 162.

Although only some wiring elements 108 are shown in the first row 110, in the second row 112, in the third row 114, and in the fourth row 116 in Figure 2, the described sequence of wiring elements 108 may be continued in accordance with the mentioned ordering scheme. Furthermore, also additional rows may be provided (not shown).

Again referring to Figure 2, all wiring elements 108 are arranged at centers of hexagonal virtual cells 126 into which the wiring plane 162 may be virtually divided. As shown, each of said hexagonal virtual cells 126 are adjacent one to the other without gaps in between. Thus, adjacent hexagonal virtual cells 126 share a respective side. Descriptively speaking, the entire wiring plane 162 may be subdivided into the hexagonal virtual cells 126 which are arranged side by side without gaps in between. Each of said hexagonal virtual cells 126 is delimited by a regular hexagon having six angles, β, with 120° each. The hexagonal virtual cells 126 form a Voronoi pattern.

For example, the wiring elements 108 of the wiring plane 162 may function for distributing electric power in the component carrier 100, more specifically in the core 122 thereof. Such electric power may be used for operating surface mounted component 118. For example, some of the wiring elements 108 may function for distributing electric signals in the component carrier 100. For instance, said signals may be signals for driving the surface mounted component 118 and/or signals provided by surface mounted component 118. Yet other of the wiring elements 108 may function for providing a reference potential, in particular a ground potential, in the component carrier. Yet other of the wiring elements 108 may function for distributing heat. For properly operating a surface mounted electronic component 118, it may also be necessary to provide a ground potential or a return current path. In an embodiment, wiring elements 108 functioning for distributing electric power or signals or a ground potential may be those provided on the first row 110 or on the second row 112 or on the third row 114 or on the fourth row 116. Other of the wiring elements 108 with a different function may be provided in another one of the first row 110 or the second row 112 or the third row 114 or the fourth row 116.

When designing component carrier 100, the wiring elements 108 may be arranged so as to comply with a predefined specification, for example in terms of current carrying capability or ampacity. In this context, the above-mentioned parameters (such as b, f, h) and/or other parameters and/or attributes (for instance the design of virtual cells 126) may be selected appropriately for achieving compliance with the specification or the requirements of at least one target attribute, function or property of the component carrier 100. For example, this can be done by a computer fit or manually.

To put it shortly, Figure 2 shows a plan view of wiring plane 162 illustrated in Figure 1. Each wiring plane 162, 164, 165, ..., can be subdivided into a plurality of Voronoi cells which are here embodied as hexagonal virtual cells 126. As shown, the regular hexagonal virtual cells 126 have six sides with a mutual 120° angle in between and being directly in contact with adjacent cells. Thereby, no empty space or area is created in between the regular hexagonal virtual cells 126. By this virtual division of the respective wiring plane 162, 164, 165 in virtual cells 126, the entire area or part thereof may be covered. Wiring elements 108, 108', 108" of the electrically conductive layer structures 104, 104', 104" of the respective wiring plane 162, 164, 165 may be arranged all in centres of the regular hexagonal virtual cells 126. By taking this measure, a regular pattern is obtained which allows to maintain minimum distances between adjacent wiring elements 108, 108', 108", which may be required for electric safety purposes according to a specification to be met. By the arrangement in the various rows 110, 112, 114, 116, and by the mutual offset, f, between adjacent rows 110, 112, 114, 116, a highly symmetric pattern may be achieved which may meet simultaneously electric demands of a certain application. For optimizing a design, it may be possible to fit the position of the wiring elements 108, 108', 108" and/or the dimension and positions of the virtual cells 126 to achieve appropriate, or even the best, results. For instance, fitting parameters may be a length of a side of the regular hexagonal virtual cells 126, an area of the wiring elements 108, 108', 108" in the respective wiring plane 162, 164, 165, the offset value, f, etc.

Although not shown in Figure 1, a surface finish may be provided, such as a gold layer and/or a layer of solder resist.

Furthermore, it is possible - also in the embodiment of Figure 1 - that one or more components are embedded in the stack 102, in particular in the core 122. Therefore, the patterned wiring 108, 108', 108" may comprise at least one empty location or vacancy. Even if the embedding is strategically planned to avoid disruption of the power distribution network of wiring elements 108, 108', 108", the embedded component can be part of the power distribution network itself. Hence, there may be a possibility of having an empty location, in particular in the straight disposition of the vertical structures. Even if the embedding is strategically planned to avoid disruption of the power distribution network of wiring elements 108, 108', 108", the embedded component can be part of the power distribution network itself. Hence, there may be a possibility of having an empty location, in particular in the straight disposition of the vertical structures.

**Figure 3** illustrates a plan view of wiring plane 162 of a component carrier 100 according to an exemplary embodiment suitable to be implemented withthe the invention. Figure 3 shows further auxiliary lines 166 extending from a respective wiring element 108 to a corner 170 or a side 171 of the hexagonal virtual cells 126. Also such parameters may be design parameters for designing a component carrier 100 in compliance with predefined target electric properties.

**Figure 4** illustrates a plan view of a wiring plane 162 of a component carrier 100 according to another exemplary embodiment suitable to be implemented with the present invention.

In addition to wiring elements 108 located in centers of the respective hexagonal virtual cells 126, Figure 4 shows an embodiment in which in addition another part of the wiring elements 108 are arranged at corners 170 of the hexagonal virtual cells 126. For example, the part of the wiring elements 108 arranged at the centers of the hexagonal virtual cells 126 may provide a first electric function (for example a power supply function), and the other part of the wiring elements 108 arranged at the corners 170 of the hexagonal virtual cells 126 may provide a second electric function (for example a signal transmission function) being different from the first electric function.

In Figure 4, the first row 110 of equidistant wiring elements 108 and the second row 112 of equidistant wiring elements 108 both extend along the same horizontal straight direction, but are also in alignment what concerns a further straight direction perpendicular to said horizontal straight direction. In the example of Figure 4, rows 110, 112 are defined by a sequence of wiring elements 108 from first row 110, then from second row 112, then from first row 110, then from second row 112, and so on. For mapping the wiring elements 108 of the second row 112 onto the wiring elements 108 of the first row 110, it is thus sufficient to shift the wiring elements 108 of the second row 112 with respect to the wiring elements 108 of the first row 110 by the offset value, f, along said horizontal straight direction towards the left-hand side of Figure 4. In the illustrated embodiment, the wiring elements 108 in the centers of the hexagonal virtual cells 126 may form the first row 110 while the wiring elements 108 in the corners 170 of the hexagonal virtual cells 126 may form the second row 112. Here, the offset value, f, of the equidistant wiring elements 108 of the second row 112 with respect to the equidistant wiring elements 108 of the first row 110 along the straight direction is 1/3 of a mutual spacing, b, between adjacent equidistant wiring elements 108 of the first row 110 or of the second row 112.

As shown, a smallest distance (which equals to the offset value, f, in the shown embodiment) of a wiring element 108 of the second row 112 from a wiring element 108 of the first row 110 is 1/3 of a mutual spacing, b, between adjacent equidistant wiring elements 108 of the first row 110 or of the second row 112.

In Figure 4, the second row 112 is aligned with the first row 110. A third row 114 and a fourth row 116 are also aligned which each other but are spaced with respect to the first row 110 and the second row 112 along the perpendicular straight direction by the offset value, h.

It is also possible that the wiring elements 108 of the wiring plane 162 of Figure 4 are grouped into a plurality of wiring element groups (which may correspond to the various rows 110, 112, 114, 116) of different electric functions, for instance are assigned to different electric voltage levels and/or to different electric current carrying capabilities.

As already mentioned, the wiring elements 108 of Figure 4 are not only arranged in centres of the hexagonal virtual cells 126, but also at corners 170 thereof. For instance, the wiring elements 108 in the centres may have a first electric function, whereas the wiring elements 108 on the corners 170 may have another second electric function. For example, the wiring elements 108 in the centres and in the corners 170 may relate to different electric potentials. It is also possible that the wiring elements 108 in the centres provide electric power, whereas the wiring elements 108 in the corners 170 provide reference potentials or signals (or vice versa).

**Figure 5** illustrates a cross-sectional view of part of a component carrier 100 according to the present invention. **Figure 6** illustrates a plan view of part of a wiring plane 162 of the component carrier 100 according to Figure 5.

Referring to Figure 5, a detail of core 122 with connected portions of build-ups 150, 152 are illustrated. In particular, conductive areas 111 - which may also be denoted as lands or land pads - are provided for interconnecting wiring elements 108, 108', 108". Figure 5 also shows respective distances, d, between adjacent conductive areas 111 of a respective wiring plane (indicated with reference signs 162, 164, 165, in a similar way as in Figure 1).

Moreover, diameters of wiring elements 108, 108', 108" are indicated with reference signs D1. As shown, wiring elements 108 of wiring plane 162 having vertical sidewalls and a cylindrical design are provided with a constant diameter D1 along their vertical extension. Further and other wiring elements 108', 108" of wiring planes 164, 165 have slanted sidewalls and a frustoconical shape, and a minimum diameter thereof is indicated as said diameter D1. Of course, the respective diameters, D1, of the various wiring elements 108, 108', 108" may be different. In particular, wiring elements 108 (which may be metal filled mechanically drilled through holes) may have a larger diameter, D1, than further/other wiring elements 108', 108" (which may be metal filled laser vias).

Furthermore, diameters of lands or conductive areas 111 are shown with reference sign D2. Different conductive areas 111 may have the same or different diameters, D2.

As shown in Figure 5, the upper conductive area 111 assigned to wiring element 108 on the right-hand side of Figure 5 is connected to a plurality of further wiring elements 108'. Hence, said further wiring elements 108' may also be connected directly to said annular conductive area 111 in an efficient way. In the embodiment of Figure 5, each of the other conductive areas 111 is connected only to a single assigned further wiring element 108' or 108". More specifically, the lower conductive area 111 assigned to the wiring element 108 on the right-hand side of Figure 5 is connected with a single other wiring element 108". Beyond this, the upper conductive area 111 assigned to the wiring element 108 on the left-hand side of Figure 5 is connected with a single further wiring element 108'. Furthermore, the lower conductive area 111 assigned to the wiring element 108 on the left-hand side of Figure 5 is also connected with a single other wiring element 108" only.

Still referring to Figure 5, the illustrated upper conductive areas 111 are coplanar and are provided with a mutual lateral spacing, d. Correspondingly, the illustrated lower conductive areas 111 are also coplanar and are provided with a mutual lateral spacing, d. The upper and lower conductive areas 111 are vertically spaced with respect to each other by a spacing corresponding to the length of the wiring elements 108.

Now referring to Figure 6, a plan view of wiring elements 108 of a wiring plane (for instance 162) is shown which are arranged side by side. In addition to the respective wiring element 108, a corresponding land or conductive area 111 is shown as well. A land or conductive area 111 may be a circular or annular structure extending laterally beyond an assigned wiring element 108. Adjacent wiring elements 108 with lands or conductive areas 111 are spaced by distance, d. The diameter of the respective wiring elements 108 are denoted as D1. The diameter of a respective land or conductive area 111 is denoted as D2. Parameter values such as D1, D2 and d can be used as design parameters or fitting parameters for optimizing the electric performance of a wiring plane 162.

When designing component carrier 100, this may comprise determining a spatial distribution of wiring elements 108 and lands or conductive areas 111, land diameter D2, hole (in particular drill) diameter D1 and a functional grouping of the wiring elements 108 complying with a predefined specification (such as a design file). In other words, the specification may define target properties of the component carrier 100 to be designed and to be subsequently manufactured. Said distribution of wiring elements 108 including lands or conductive areas 111, the parameters d, D1 and D2, as well as the grouping of the wiring elements 108 to provide a certain (in particular electric) function in the framework of the component carrier 100 may then be adjusted accordingly. Spacing, d, between adjacent lands or conductive areas 111 of adjacent wiring elements 108 may be a further design parameter to be adjusted in this context. Also a minimum distance for a hexagonal virtual cell 126, Md, and/or a pitch, P, may be introduced in the determination process. The pitch, P, may define the center-to-center distance between adjacent wiring elements 108. Thus, the mentioned considerations may be taken into account when defining a core drilling set up. By correspondingly executing core drilling and at least partially filling with electrically conductive material (e.g. metal) resulting in a wiring element 108, for example a target ampacity of the component carrier 100 may be achieved.

Referring to Figure 6, the following formulas apply: $Md = \frac{1}{2} D 2 + d + D 2 + d + \frac{1}{2} D 2$ $P = \frac{1}{2} D 2 + d + \frac{1}{2} D 2$

The resulting minimum geometries are something that can be addressed modifying some of the same rules, which are driving the pitch, like for example the possibility of differentiating the diameter of the mechanically drilled through hole. The resulting pitch can then be modified to further enable other significant changes, such as enlarging some holes in respect of others. This may then establish a differential contribution to the overall characteristics of the substrate.

According to a preferred embodiment, a component carrier 100 may be designed for example with a configuration of stack 102 according to Figure 1 or Figure 5. For instance, a respective wiring plane 162, 164, 165 may be configured in accordance with rows 110, 112, ... of equidistant wiring elements 108, 108', 108", with or without mutual offset. For example, an arrangement of the wiring elements 108, 108', 108" may be in accordance with a Voronoi pattern according to Figure 2 or Figure 4. Wiring elements 108, 108', 108" may be interconnected using conductive areas 111, as shown for example in Figure 5 or Figure 6.

According to a particularly preferred design rule, each of the conductive areas 111 of a respective electrically conductive layer structure 104, 104', 104" being connected with at least two wiring elements 108, 108', 108" is spaced by a distance, d, from a respective other conductive area 111 connected to an adjacent wiring element 108, 108', 108" so that said distance, d, is at least 5% (preferably at least 10%, for instance not more than 30%) of a diameter, D1, of the respective wiring element 108, 108', 108". In other words, a ratio between the distance, d, between adjacent land-type conductive areas 111 at the same vertical level and a (in particular constant or minimum) diameter D1 of at least one connected wiring element 108, 108', 108" of at least one wiring plane 162, 164, 165 shall be at least 5%. In particular, said ratio of at least 5% may be the ratio between the distance, d, between adjacent conductive areas 111 at the same vertical level and a diameter, D1, of a wiring element 108 (in particular corresponding to a metal filled mechanically drilled through hole) of wiring plane 162 (in particular of the wiring plane 162 relating to core 122) connected to one of said conductive areas 111. With this design rule, a reliable electric separation of different conductive areas 111 and connected wiring elements 108, 108', 108" may be guaranteed even when conducting high values of electric current. Hence, a high electric reliability may then be combined with a high electric performance.

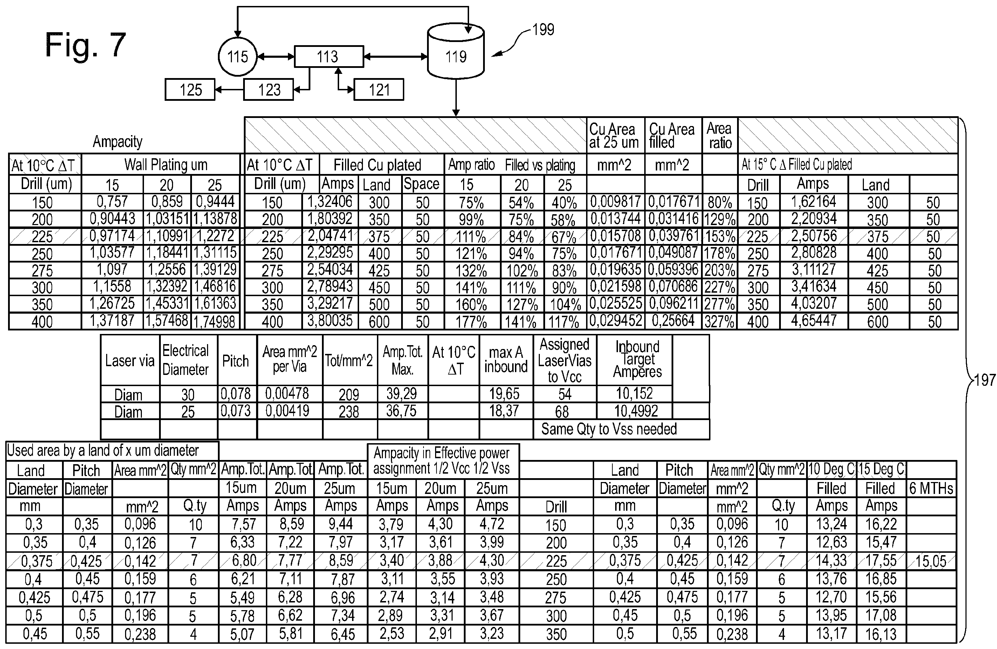

**Figure 7** illustrates constituents of a computer-based system 199 for defining a distribution of wiring elements 108 for component carrier 100 to be designed, and illustrates a table 197 with parameters defining structure and performance of the component carrier 100 according to an exemplary embodiment suitable to be implemented with the present invention. When a component carrier 100 is designed according to Figure 7, the model and the parameters and attributes according to Figure 5 and Figure 6 may be taken into account. In particular, the above described "at least 5% distance" design rule may be taken into account for designing and subsequently manufacturing a component carrier 100.

Now referring to Figure 7 in further detail, when designing a component carrier 100 to be manufactured subsequently, it may be possible to define the distribution of the wiring elements 108 in accordance with certain requirements by a processor 113. Said requirements may be correlated with some of the parameter values of table 197, which may be stored in a database 119 (which may be realized by a mass storage device such as a hard disk). Processor 113, which may form part of a computer (not shown), may carry out calculations for virtually designing component carrier 100. For defining the distribution of the wiring elements 108 for component carrier design supported by the processor 113, it may be possible to execute a suitable fitting algorithm. Said fitting algorithm may vary several degrees of freedom but may maintain a target current-related value, such as a target ampacity of the designed component carrier 100, fixed. A set of predefined parameters may be considered as well as fixed boundary conditions for the fit. In order to support processor 113 during virtually designing a component carrier 100, a distribution of the wiring elements 108 may be determined in accordance with said requirements using an artificial intelligence module 115 (which may for instance comprise a neural network). As shown, computer-based system 199 may also comprise an input/output unit 121 (such as a user interface) by which a human operator, such as a design engineer, may input parameters to be considered for the design or fit. Furthermore, output parameters of a design or fit may be output to the human operator by input/output unit 121. When a design for component carrier 100 has been defined in compliance with one or more target current-related values (such as a target ampacity) and meeting further possible input definitions (such as the above mentioned "at least 5%" design rule), computer-based system 199 may output a correspondingly constructed design file 123 summarizing all parameters needed for manufacturing the component carrier 100. Such a design file 123 may be sent (in particular after approval by the human operator) to a component carrier manufacturing apparatus 125 for physically manufacturing the component carrier 100 in accordance with the derived design. Thus, the component carrier 100 may then be manufactured in accordance with the design file 123 including the defined distribution of wiring elements 108.

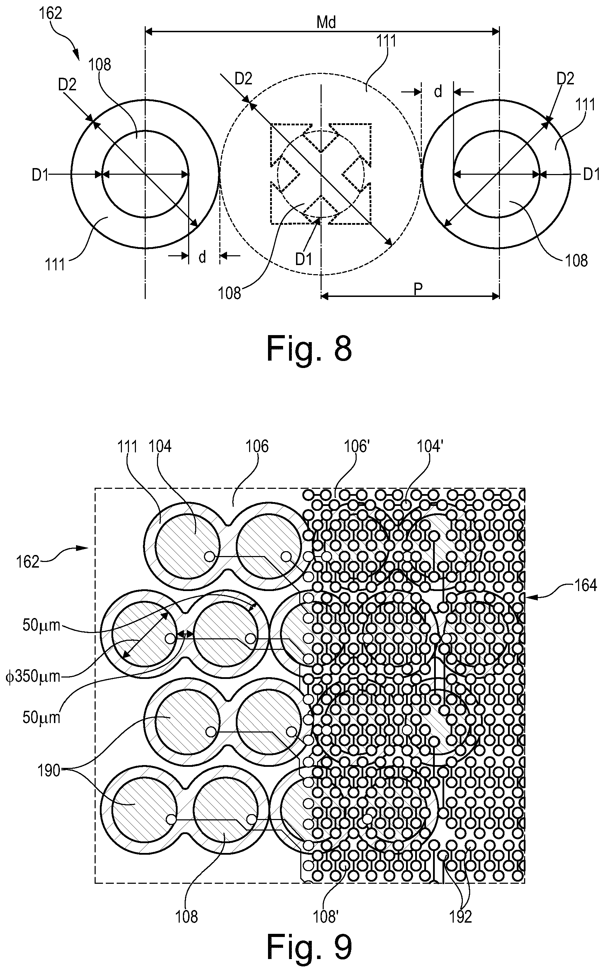

**Figure 8** illustrates a plan view of wiring elements 108 of a detail of a wiring plane 162 of a component carrier 100 according to an exemplary embodiment suitable to be implemented with the present invention. In a nutshell, Figure 8 shows a similar scenario as Figure 6, wherein Figure 8 indicates the central wiring element 108 with larger dimensions than the exterior ones.

**Figure 9** illustrates a plan view of part of overlapping wiring planes 162, 164 of a component carrier 100 according to an exemplary embodiment suitable to be implemented with the present invention illustrating mechanically drilled through holes 190 density per area of a core 122 and the density per the same area of laser drilled through holes 192 of a build-up 150. Hence, Figure 9 enables a geometrical comparison of mechanically drilled through holes 190 versus laser vias, i.e. laser drilled through holes 192. The comparison of laser via dimensions versus dimensions of plated through holes in the core 122 of the substrate-type component carrier 100 shows significant differences. In the illustrated example, diameters of the laser via lands are 60 µm. In contrast to this, the lands of the plated mechanical through holes lands have a diameter of 350 µm (related to 150 µm drilled holes), in the shown example. As shown in Figure 9, there may be major differences between the different geometries and even densities of the vertical metal structures within the substrate layers.

An entry point may be realized with small features but carrying lower currents and higher voltages. The central section of the substrate (i.e. its core 122) may handle a conversion to lower voltages and higher currents. In an upper section, a distribution or feed of the current value to the semiconductor interconnections may be accomplished. This may involve a concentration of the design into a specific area that corresponds to a shadow region 120 of the semiconductor component 118 itself.

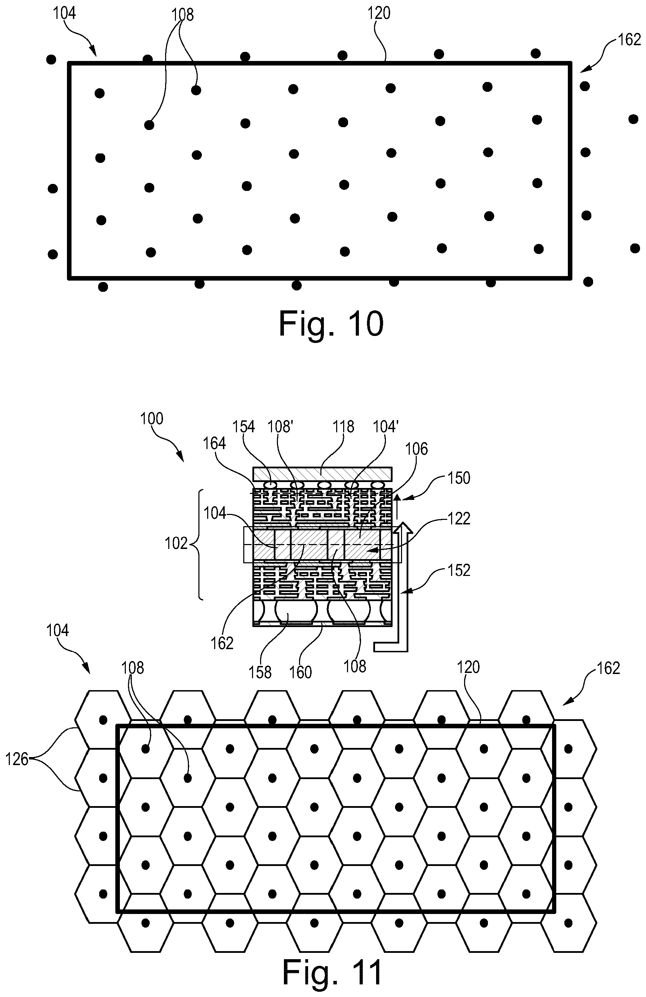

**Figure 10** illustrates a plan view of a wiring plane 162 of a component carrier 100 according to an exemplary embodiment suitable to be implemented with the present invention.

In the embodiment of Figure 10, a shadow region 120 of a surface mounted component 118 is plotted. In such a shadow region 120, such as a projection of the outline of the surface mounted electronic component 118 into the stack 102, an appropriate wiring distribution may be of particular relevance, since such a surface mounted component 118 may have a high number of I/O pads with an electric functionality which has to be guided vertically through the stack 102. Hence, when a component 118 is surface mounted on the stack 102, wiring elements 108 with the above-mentioned pattern may be arranged in shadow area 120 of the surface mounted component 118. Although not shown in Figure 10, the shadow area 120 may taper from an interior of the stack 102 towards the surface mounted component 118.

Within the mentioned shadow area 120, a power voltage and an electric ground potential may be provided. Hence, it may be possible to approach a power feeding from an optimized geometrical computation of the distribution and the configuration of the wiring elements 108.

The distribution of the power features required by predefined values of the transfer of current may be done analytically. Then, the area of interest in terms of power feeding may be used to place the structures following the concept of tessellation, for instance creating areas of competence for each power structure. The concept of applying the creation of Voronoi cells with the positioning of the power feeding mechanically drilled through holes as a seed of each Voronoi cells is shown in Figure 11:
**Figure 11** illustrates a cross-sectional view of a component carrier 100 and a plan view of a wiring plane 162 of the component carrier 100 according to an exemplary embodiment suitable to be implemented with the present invention.

The selection of the honeycomb structure of Figure 11 for defining hexagonal virtual cells 126 may be made to identify an equalized structure for the intermediate layers in the core construction to achieve a uniform contribution of power delivery to a determined closer point to the point of loads represented by the power connection of the surface mounted component 118. The core construction may have at least one additional layer (for example made with a prepreg) that may be used for a finer distribution of starting vertical structures of (for example stacked) laser vias.

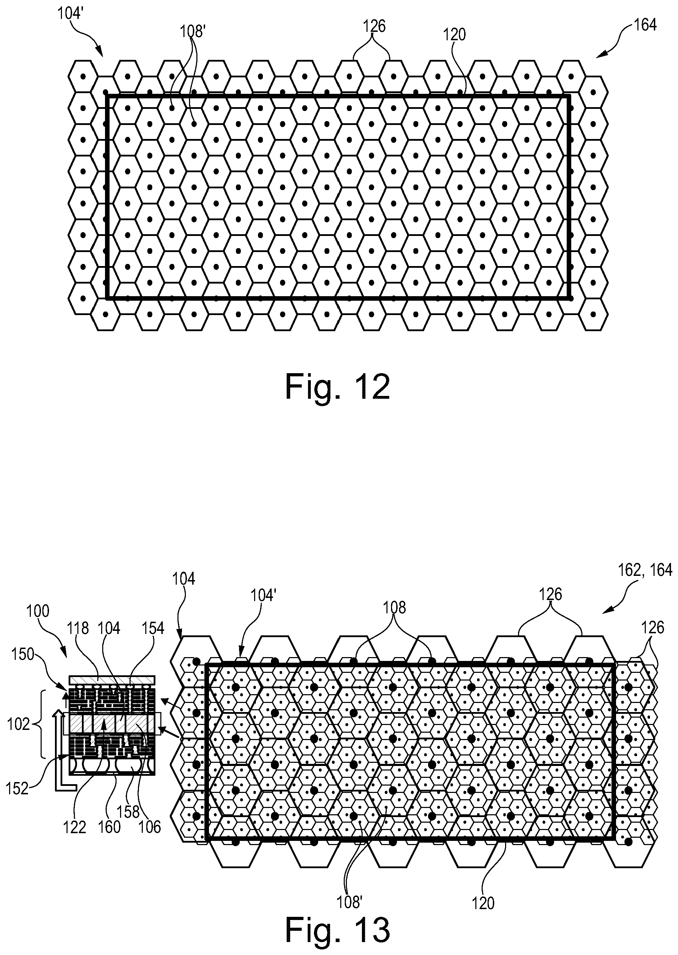

**Figure 12** illustrates a plan view of another wiring plane 164 of the component carrier 100 according to Figure 11. The other wiring plane 164 corresponds to upper build-up 150 and has a higher integration density than core 122. More specifically, a number of wiring elements 108' per area or volume may be higher in the upper build-up 150 than in the core 122. This may lead to a smaller dimension of the hexagonal virtual cells 126 in the upper build-up 150 than in the core 122.

As can be taken from Figure 11 and Figure 12, the honeycomb tessellation is scalable based on the available minimum geometries of the power feeding structures. While it is constructed into a section of the core 122 according to Figure 11, it can be applied as well (even partially) in the above layers in the build-up 150 according to Figure 12 with much smaller (scaled) dimensions.

**Figure 13** illustrates a plan view of an overlay of the wiring planes 162, 164 of Figure 11 and Figure 12.

The dimensioning operation to size the Voronoi cells may be driven by the functional requirement of the specific structures of a component carrier to be designed. In case of mechanically drilled through holes there may be limitations imposed by construction factors of the core, for example the overall total aspect ratio between drill diameter and depth of the holes (thickness of the drilled core). The technology implementation may be governed by the physical limitation of the required steps to achieve the desired result. In the case of the mechanically drilled through holes, it can be the overall resulting aspect ratio limiting the capability of plating the interior part of the vertical holes creating a conductive deposition of copper on the wall of the hole. These limitations may be summarized in design rules to be used in the design of the structures. Examples are the minimum distance between holes (land to land) or the minimum drill diameter compatible with the overall thickness of the core. These geometries may determine other geometrical dimensions that are for example the maximum density (pitch) of the structures. The maximum possible density may determine the maximum contribution of these structures based on the individual capability of a single structure.

Referring again to Figure 12, further electrically conductive layer structure 104' of the stack 102 comprises a plurality of further wiring elements 108' which are arranged in further plane 164 parallel to the wiring plane 162 and which have a corresponding pattern as but another density of wiring elements than the electrically conductive layer structure 104 with the first row 110 and the second row 112 of wiring elements 108, as shown in Figure 11. Wiring plane 162 corresponds to a cross-section through core 122, whereas wiring plane 164 corresponds to a cross-section through the upper build-up 150. Figure 11 and Figure 12 illustrate a tessellation of the die shadow area 120. It may be possible to create areas of influence for each power domain. Figure 11 and Figure 12 illustrate that different wiring planes 162, 164 may be subdivided into hexagonal virtual cells 126 (or Voronoi cells with other geometry) with different cell dimensions. The dimensions of the hexagonal virtual cells 126 in the different wiring planes 162, 164 may reflect different integration densities (for example different numbers of wiring elements 108 per area or volume) in different wiring planes 162, 164. In the shown embodiment, wiring plane 162 has a smaller integration density than wiring plane 164. This may be a result of a redistribution layer or structure in an interior of the stack 102.

Thus, Figure 11 and Figure 12 show that the described tessellation is scalable. Hence, the described technique may be adapted to specific power delivery targets and the available space.

Still referring to Figure 11 and Figure 12, two different wiring planes 162 (Figure 11) and 164 (Figure 12) are illustrated. Wiring plane 162 of Figure 11 relates to core 122 with a relatively low number of wiring elements 108 per area. In contrast to this, Figure 12 corresponds to a layer of a respective build-up 150 (or 152) which comprises a higher number of wiring elements 108' (or 108") per area or volume. According to a preferred embodiment, the arrangement of the wiring elements 108, 108' in combination with lands (see Figure 12) may be adjusted so that the wiring planes 162 and 164 can be properly electrically interconnected.

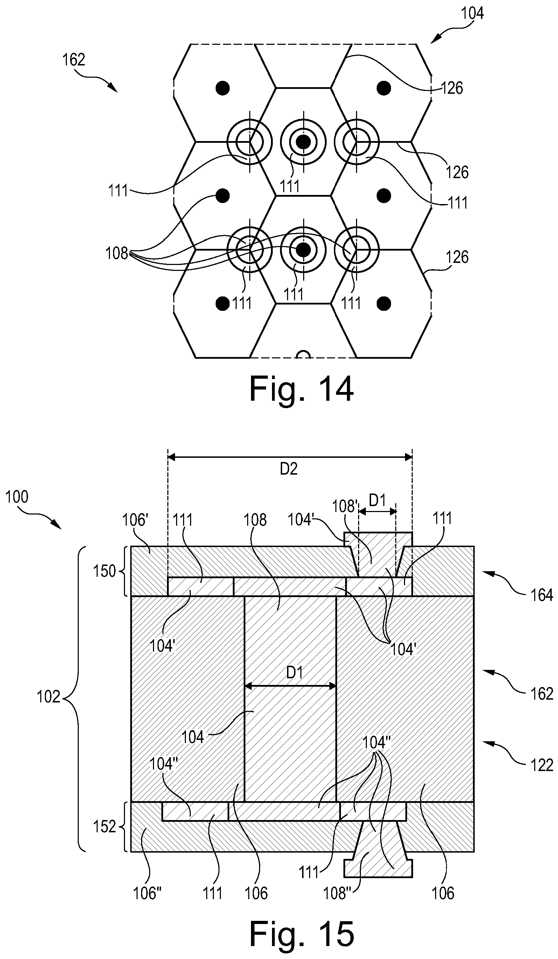

**Figure 14** illustrates a plan view of part of a wiring plane 162 of a component carrier 100 according to an exemplary embodiment of the invention. In principle, Figure 14 shows a larger portion of the wiring plane 162 of Figure 6.

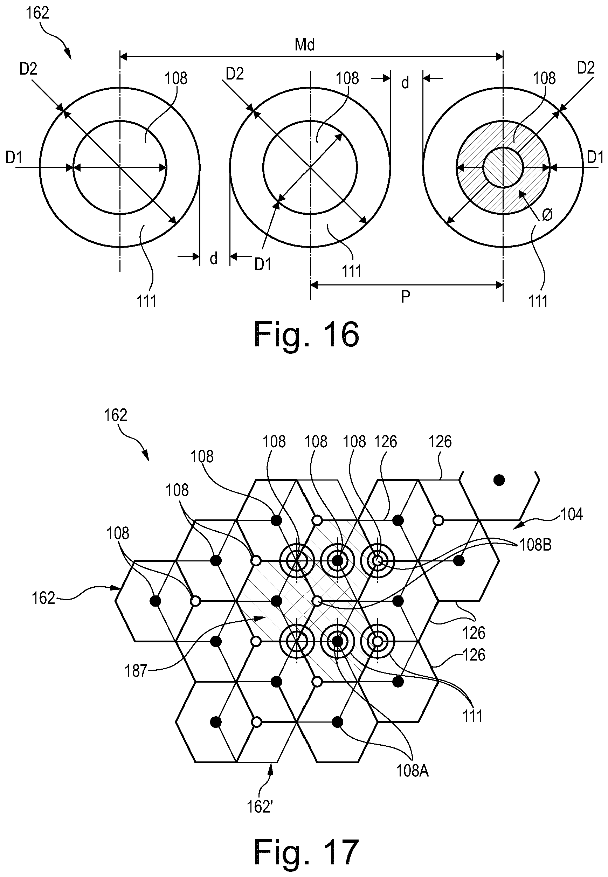

**Figure 15** illustrates a cross-sectional view of part of a component carrier 100 according to an embodiment not part of the present invention. **Figure 16** illustrates a plan view of part of a wiring plane 162 of the component carrier 100 according to an embodiment not part of the present invention. The embodiment of Figure 15 differs from the embodiment of Figure 5 in particular in that, according to Figure 15, each of the conductive areas 111 is connected to only a single assigned further wiring element 108' or 108".

To obtain a high degree of freedom of design, and to pursue a large level of Amperes delivered, differential drill diameters structures are possible. Figure 16 illustrates some possible combinations where reference (in particular ground) structures, which may be more redundant than the power feeding structures, may be kept at a smaller diameter while making the power ones larger in diameter. Consequently, a larger conductor cross section may be obtained with a marginal increment of the pitch. The latter allows to maintain, or to reach, a desired level of density within the design.

**Figure 17** illustrates a plan view of different wiring planes 162, 162' of a component carrier 100 according to an exemplary embodiment suitable to be implemented with the present invention.

Figure 17 shows an area of influence 187. Moreover, Figure 17 illustrates various kinds of wiring elements 108 in different wiring planes 162, 162', i.e. wiring elements of first type 108A in wiring plane 162 and wiring elements of second type 108B in wiring plane 162'. In the shown example, the wiring elements of first type 108A may be configured to provide a ground potential, whereas the wiring elements of second type 108B may be configured to provide a power voltage. Every point in the space is served by the wiring elements of second type 108B corresponding to the power domains. More specifically, every power providing wiring element of second type 108B is served by three redundant wiring elements of first type 108A providing an electric reference or ground potential (with possible smaller hole or drill diameters).

More generally, a determination method according to an exemplary embodiment of the invention may link one wiring element of one wiring plane to a plurality of wiring elements of the adjacent next wiring plane.

Figure 17 highlights a portion of the wiring planes 162, 162' which is denoted by reference sign 187. Such a sub-portion may be subject to optimization, fitting or adaptation.

In a dual matrix, it may not be necessary to fill all vertexes. Some may remain available to be used if requirements will impose that. On the other hand, a strategic tessellation can be also used to partition the distribution according to the mapping of the power domains. An empty vertex may provide locations for further power domains.

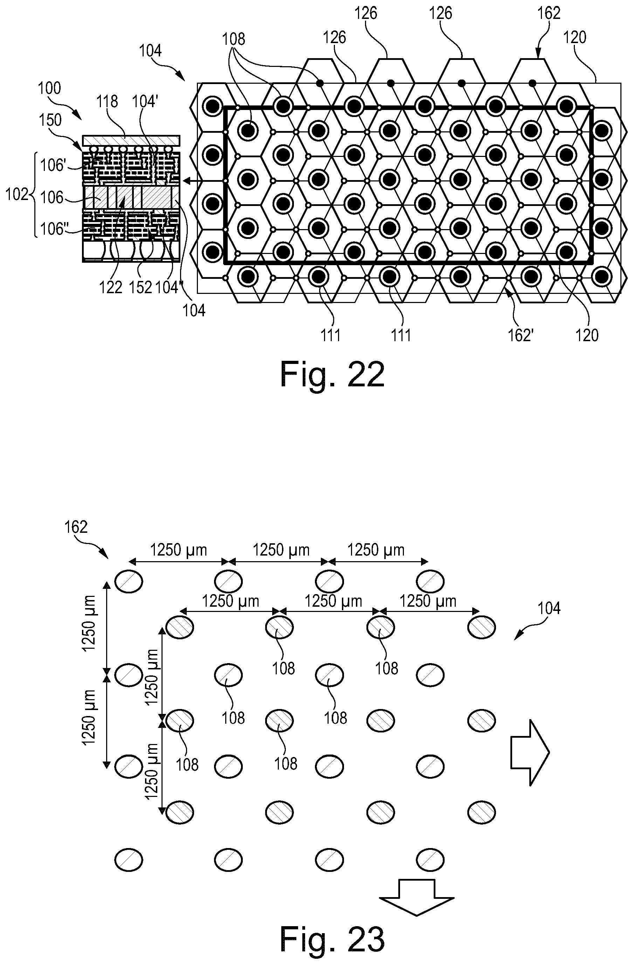

The area of influence 187 is advantageous in terms of placing and/or defining the origin of the construction of the tessellation. It also defines geometrically the potential areas for enlarging the landing zones to be used for connecting the laser vias to the mechanical through holes relating to wiring elements 108 of the core 122 with the laser vias placed into a prepreg layer of the core 122 (the equalization layer). An enlargement of the landing areas is shown in Figure 22.

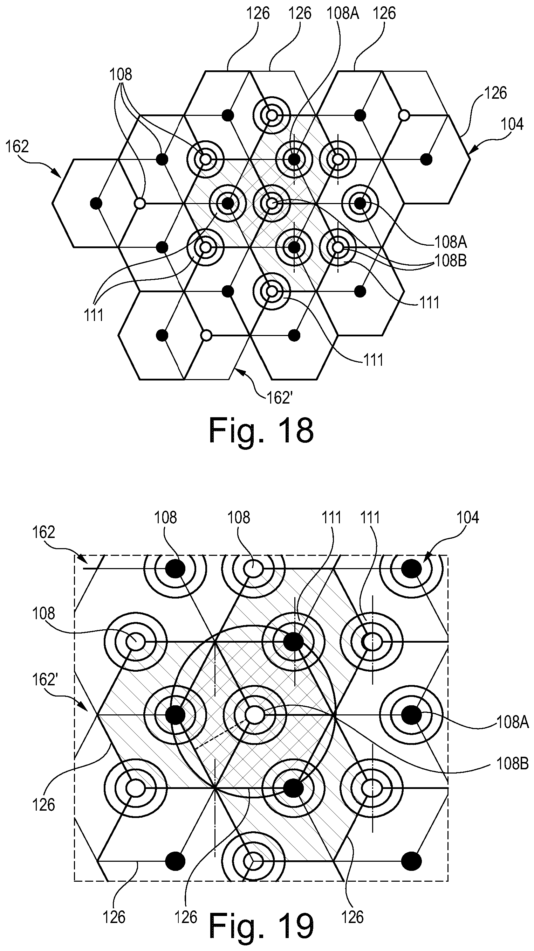

**Figure 18** illustrates a similar view as Figure 17 indicating additional conductive areas 111 around wiring elements 108. **Figure 19** illustrates a detail of Figure 18.

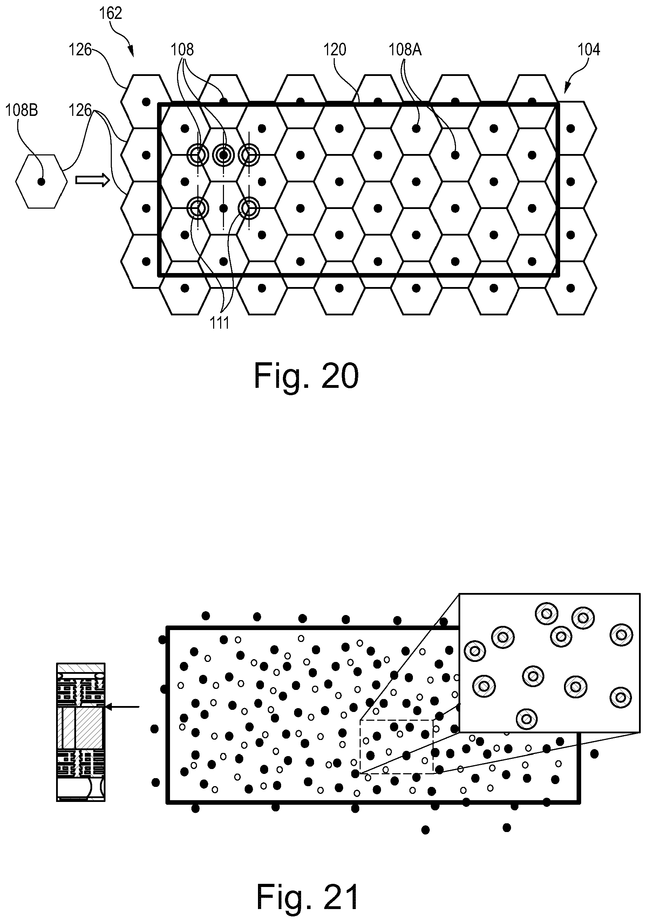

**Figure 20** illustrates a plan view of a wiring plane 162 of a component carrier 100 according to an exemplary embodiment suitable to be implemented with the present invention, to which an additional wiring element of second type 108B is added. Again, tessellation of a die shadow area 120 is illustrated in Figure 20. In particular, Figure 20 shows how to create areas of influence for each power domain. As shown, an additional wiring element of second type 108B is added to the power distribution for wiring elements of first type 108A.

Figure 20 illustrates again that also the lands or conductive areas 111 connected to the respective wiring elements 108 may be taken into account for the design of the component carrier 100.

**Figure 21** illustrates a plan view of a conventional wiring plane of a component carrier suitable to be implemented with the present invention.

Figure 21 involves power voltage and ground laser landing areas. For example, areas around wiring elements are available for laser vias landing.

Positions (pitch and rules) of mechanically drilled through holes may address placement of laser vias over the annular ring of the mechanically drilled through holes. Consequently, the position of structures may reach the related semiconductors.

If one or more shadow areas of the one or more semiconductor components is/are projected in the core, this area in the core can be used to facilitate the distribution of the feeding current through some design practices:
a) Partitioning of the area into a uniform pattern of mechanically drilled through holes.
b) The decoupling of the positioning of the power laser vias in the build-up layers in respect of the positioning of the mechanically drilled through holes used for power supply in the core. This may be accomplished by the addition of a prepreg layer in the core construction, allowing where possible a direct feeding through vertical stack of vias.
c) Using a different drilling diameter for mechanically drilled through holes used for power supply compared to others like those for transport of signals and provision of a ground potential.
d) Allowing enough redundancy to protect the power network circuit from current transients through the use of thick copper layers into the core construction and redundant parallelization of the vertical structures.
e) Use of build-up layers assigned to power supply and provision of ground potential to a hybrid configuration to assist the final delivery design.

Partitioning of the shadow area may be performed on a selected (and selectable) grid of coordinates of centers of mechanically drilled through holes.

These may be sizeable based on the level of the targeted current density per desired unit of surface (for example square millimeter).

Figure 21 illustrates a conventional approach that places structures opportunistically and not with a precise pre-ordinated plan, resulting in a random placement without a precise relation between the quantity of the inbound structures currents and outbound structures carrying currents. The enlargement of Figure 21 illustrates the limited areas for landing laser vias onto the top surface of capped mechanical through holes, when an equalizer layer is missing in the construction of the core.

Contrary to the conventional approach of Figure 21, the below described embodiment of the invention according to Figure 22 makes it possible that the areas for landing the power laser vias are greatly extended and normalized by an equalizer layer that helps in the placement of the laser vias stacks reaching vertically the semiconductor's bump pads (see reference sign 154 in Figure 1).

**Figure 22** illustrates a plan view of different wiring planes 162, 162' of a component carrier 100 according to an exemplary embodiment suitable to be implemented with the present invention.

According to Figure 22, power voltage supply and provision of a reference potential (such as ground potential) may be accomplished by a tessellation overlay of wiring elements 108 in different wiring planes 162, 162'. In the illustrated distribution scheme, power laser vias on top/bottom prepregs can be placed in any of the illustrated solid areas to align with build-up stacked vias.

Figure 22 illustrates available areas for landing laser vias within the prepregs, which have a much higher possibility of being aligned to the required vertical stack of laser vias constructed in the build-up layers to reach the semiconductor bumps directly with an optimized structure with the best possible ampacity.

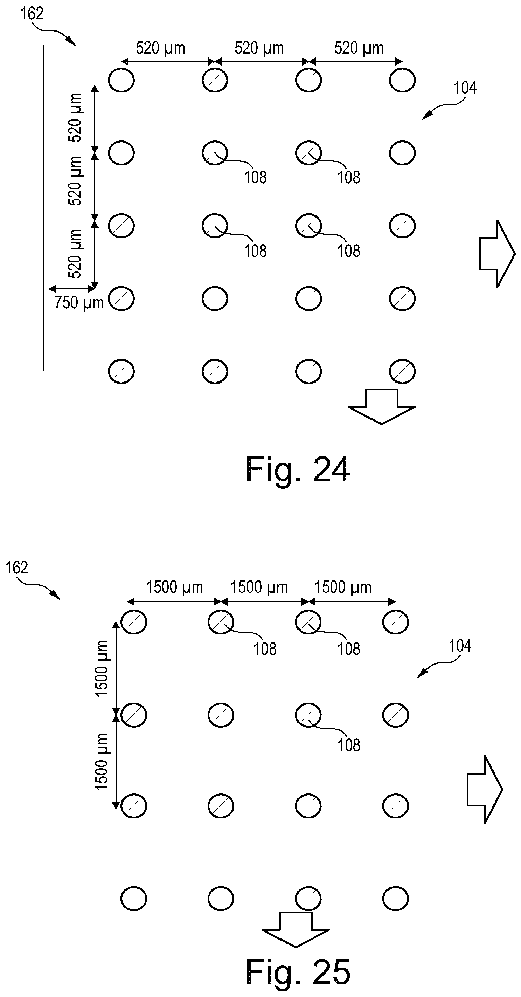

**Figure 23****,** **Figure 24,** and **Figure 25** each illustrate a plan view of a respective wiring plane 162 of a component carrier 100 according to an exemplary embodiment suitable to be implemented with the present invention. In all three embodiments, matrix-like arrangements of wiring elements 108 are displayed addressing different level of density of current or signal transfer across the stack of layers according to the defined product specification and interface interconnection mapping.

**Figure 26** illustrates a plan view of different wiring planes 162, 162' of a component carrier 100 according to an exemplary embodiment suitable to be implemented with the present invention. Figure 26 illustrates that a method of distributing wiring elements 108 may comprise arranging the wiring elements 108 in accordance with hexagonal Voronoi cells 126 around respective wiring elements 108 and by combining sets of wiring elements 108 of neighbouring hexagonal Voronoi cells 126 to four-sided blocks 124. The latter may be parallelogram-type blocks. The arrangement of Figure 26 is compliant with an ampacity target of 10 A/mm². Figure 26 shows a coverage in the die shadow area 120.

Every point in the space may be served by the power domains. Six hexagons (for example of 447 µm side length) are shown with their mechanically drilled through holes (for instance of 225 µm drill diameter), and are filled with electrically conductive material. Copper paste can carry about 10 A in areas of 1.192 mm² and a temperature difference of 10° C. Current density is shown through a different geometrical space tessellation per 1 mm² unit of surface.

**Figure 27** illustrates a plan view of a wiring plane 162 of a component carrier 100 according to an exemplary embodiment suitable to be implemented with the present invention. Figure 27 shows that the different wiring elements 108 in centers, in corners or elsewhere in relation to the hexagonal virtual cells 126 may also have different sizes. A cross-sectional area of a wiring element 108 may have an impact on, for example, its current carrying capability.

It should be noted that the term "comprising" does not exclude other elements or steps and the "a" or "an" does not exclude a plurality. Also elements described in association with different embodiments may be combined.

It should also be noted that reference signs in the claims shall not be construed as limiting the scope of the claims.

## Claims

1. A component carrier (100), which comprises:
a stack (102) comprising at least two electrically insulating layer structures (106, 106', 106") and at least one electrically conductive layer structure (104, 104', 104");
a plurality of wiring elements (108) provided in one of the at least two electrically insulating layer structures (106), said plurality of wiring elements (108) being arranged in a wiring plane (162) to form:
a first row (110) of equidistant wiring elements (108) arranged along a straight direction within the wiring plane (162); and
a second row (112) of equidistant wiring elements (108) arranged along the straight direction within the wiring plane (162);
a plurality of further wiring elements (108') provided in another of the at least two electrically insulating layer structures (106');
wherein the at least one electrically conductive layer structure (104, 104', 104") comprises several conductive areas (111) being electrically insulated with respect to each other, each of said conductive areas (111) being connected to at least one of the plurality of wiring elements (108) and to at least one of the plurality of further wiring elements (108'); and
wherein each of the conductive areas (111) of the at least one electrically conductive layer structure (104, 104', 104") is spaced by a distance (d) from a respective conductive area (111) connected to an adjacent wiring element (108, 108'), wherein said distance (d) is at least 5% of a diameter (D1) of the wiring element (108, 108');
**characterized in that**
an amount of further wiring elements (108') connected to a respective conductive area (111) which is connected to a wiring element (108) of the first row (110) is higher than an amount of the further wiring elements (108') connected to the respective conductive area (111) which is connected to a wiring element (108) of the second row (112),
and **in that**
an amount of further wiring elements (108') connected to a larger conductive area (111) is higher than an amount of further wiring elements (108') connected to a smaller conductive area (111).

2. The component carrier (100) according to claim 1, wherein the wiring elements (108) of the second row (112) are provided with an offset along the straight direction with respect to the wiring elements (108) of the first row (110).

3. The component carrier (100) according to any of claims 1 to 2, wherein at least part of the wiring elements (108) are arranged at centers of hexagonal virtual cells (126) of the wiring plane (162), each of said hexagonal virtual cells (126) being adjacent one to the other sharing a respective side of a respective hexagon with a respective adjacent hexagon.

4. The component carrier (100) according to any of claims 1 to 3, wherein the plurality of further wiring elements (108') are arranged in a further wiring plane (164) parallel to the wiring plane (162) and in accordance with a corresponding pattern as but another density of wiring elements than the first row (110) and the second row (112) of wiring elements (108).

5. The component carrier (100) according to any of claims 1 to 4, wherein at least part of the conductive areas (111) are land pads.

6. The component carrier (100) according to any of claims 1 to 5, wherein at least part of the conductive areas (111) have a planar annular shape surrounding a respective one of the wiring elements (108).

7. The component carrier (100) according to any of claims 1 to 6, wherein at least part of the conductive areas (111) are circular and are aligned coaxially with an axis of a respective wiring element (108).

8. The component carrier (100) according to any of claims 1 to 7, comprising at least one of the following features:
adjacent wiring elements (108) of said electrically insulating layer structure (106) have different cross-sectional areas;
adjacent further wiring elements (108') of said other electrically insulating layer structure (106') have the same cross-sectional areas;
further wiring elements (108') connected to the respective conductive area (111) have different cross-sectional areas than those of the further wiring elements (108') connected to the conductive area (111) which is connected to the adjacent wiring element (108).

9. The component carrier (100) according to any of claims 1 to 8, wherein at least one of said conductive areas (111) is electrically connected with at least two of said further wiring elements (108').

10. The component carrier (100) according to any of claims 1 to 9, wherein the further wiring elements (108') have a smaller dimension, in particular a smaller diameter (D1), compared with a larger dimension, in particular a larger diameter (D1), of the wiring elements (108).

11. The component carrier (100) according to any of claims 1 to 10,
comprising a plurality of still other wiring elements (108") provided in still another of the at least two electrically insulating layer structures (106") on an opposing side of said electrically insulating layer structure (106) in relation to said other electrically insulating layer structure (106');
wherein some conductive areas (111) are connected to at least one of the plurality of wiring elements (108) and to at least one of the plurality of still other wiring elements (108"); and
wherein each of said some conductive areas (111) is spaced by a distance (d) from a respective conductive area (111) connected to an adjacent wiring element (108), wherein said distance (d) is at least 5% of a diameter (D1) of the wiring element (108).

12. A method of manufacturing a component carrier (100), wherein the method comprises:
providing a stack (102) comprising at least two electrically insulating layer structures (106, 106', 106") and at least one electrically conductive layer structure (104, 104', 104");
forming a plurality of wiring elements (108) in one of the at least two electrically insulating layer structures (106), said plurality of wiring elements (108) being arranged in a wiring plane (162) to form:
a first row (110) of equidistant wiring elements (108) arranged along a straight direction within the wiring plane (162); and
a second row (112) of equidistant wiring elements (108) arranged along the straight direction within the wiring plane (162);
forming a plurality of further wiring elements (108') in another of the at least two electrically insulating layer structures (106');
forming the at least one electrically conductive layer structure (104, 104', 104") so as to comprise several conductive areas (111) being electrically insulated with respect to each other, each of said conductive areas (111) being connected to at least one of the plurality of wiring elements (108) and to at least one of the plurality of further wiring elements (108'); and
forming each of the conductive areas (111) of the at least one electrically conductive layer structure (104, 104', 104") so as to be spaced by a distance (d) from a respective conductive area (111) connected to an adjacent wiring element (108, 108'), wherein said distance (d) is at least 5% of a diameter (D1) of the wiring element (108, 108');
**characterized in that**
an amount of further wiring elements (108') connected to a respective conductive area (111) which is connected to a wiring element (108) of the first row (110) is higher than an amount of the further wiring elements (108') connected to the respective conductive area (111) which is connected to a wiring element (108) of the second row (112),
and **in that**
an amount of further wiring elements (108') connected to a larger conductive area (111) is higher than an amount of further wiring elements (108') connected to a smaller conductive area (111).

## Patentansprüche

1. Komponententräger (100), umfassend:
einen Stapel (102), umfassend mindestens zwei elektrisch isolierende Schichtstrukturen (106, 106', 106") und mindestens eine elektrisch leitfähige Schichtstruktur (104, 104', 104");
eine Vielzahl von Verdrahtungselementen (108), die in einer der mindestens zwei elektrisch isolierenden Schichtstrukturen (106) bereitgestellt sind, wobei die Vielzahl von Verdrahtungselementen (108) in einer Verdrahtungsebene (162) angeordnet ist, um Folgendes zu bilden:
eine erste Reihe (110) von äquidistanten Verdrahtungselementen (108), die entlang einer geraden Richtung innerhalb der Verdrahtungsebene (162) angeordnet sind; und
eine zweite Reihe (112) von äquidistanten Verdrahtungselementen (108), die entlang der geraden Richtung innerhalb der Verdrahtungsebene (162) angeordnet sind;
eine Vielzahl von weiteren Verdrahtungselementen (108'), die in einer anderen der mindestens zwei elektrisch isolierenden Schichtstrukturen (106') bereitgestellt sind;
wobei die mindestens eine elektrisch leitfähige Schichtstruktur (104, 104', 104") mehrere leitfähige Bereiche (111) umfasst, die elektrisch voneinander isoliert sind, wobei jeder der leitfähigen Bereiche (111) mit mindestens einem der Vielzahl von Verdrahtungselementen (108) und mit mindestens einem der Vielzahl von weiteren Verdrahtungselementen (108') verbunden ist; und
wobei jeder der leitfähigen Bereiche (111) der mindestens einen elektrisch leitfähigen Schichtstruktur (104, 104', 104") durch einen Abstand (d) von einem entsprechenden leitfähigen Bereich (111) beabstandet ist, der mit einem benachbarten Verdrahtungselement (108, 108') verbunden ist, wobei der Abstand (d) mindestens 5 % eines Durchmessers (D1) des Verdrahtungselements (108, 108') beträgt;
**dadurch gekennzeichnet, dass**
eine Anzahl weiterer Verdrahtungselemente (108'), die mit einem entsprechenden leitfähigen Bereich (111) verbunden ist, der mit einem Verdrahtungselement (108) der ersten Reihe (110) verbunden ist, höher ist als eine Anzahl der weiteren Verdrahtungselemente (108'), die mit dem entsprechenden leitfähigen Bereich (111) verbunden ist, der mit einem Verdrahtungselement (108) der zweiten Reihe (112) verbunden ist,
und dadurch, dass
eine Anzahl weiterer Verdrahtungselemente (108'), die mit einem größeren leitfähigen Bereich (111) verbunden ist, höher ist als eine Anzahl weiterer Verdrahtungselemente (108'), die mit einem kleineren leitfähigen Bereich (111) verbunden ist.

2. Komponententräger (100) nach Anspruch 1, wobei die Verdrahtungselemente (108) der zweiten Reihe (112) mit einem Versatz entlang der geraden Richtung in Bezug auf die Verdrahtungselemente (108) der ersten Reihe (110) bereitgestellt sind.

3. Komponententräger (100) nach einem der Ansprüche 1 bis 2, wobei mindestens ein Teil der Verdrahtungselemente (108) in Mitten von hexagonalen virtuellen Zellen (126) der Verdrahtungsebene (162) angeordnet ist, wobei jede der hexagonalen virtuellen Zellen (126) benachbart zueinander ist und eine entsprechende Seite eines entsprechenden Hexagons mit einem entsprechenden benachbarten Hexagon gemeinsam nutzt.

4. Komponententräger (100) nach einem der Ansprüche 1 bis 3, wobei die Vielzahl von weiteren Verdrahtungselementen (108') in einer weiteren Verdrahtungsebene (164) parallel zu der Verdrahtungsebene (162) und gemäß einem entsprechenden Muster wie das der ersten Reihe (110) und der zweiten Reihe (112) von Verdrahtungselementen (108), jedoch mit einer anderen Dichte von Verdrahtungselementen (108) als die erste Reihe (110) und die zweite Reihe (112) von Verdrahtungselementen (108) angeordnet ist.

5. Komponententräger (100) nach einem der Ansprüche 1 bis 4, wobei mindestens ein Teil der leitfähigen Bereiche (111) Kontaktflächen sind.

6. Komponententräger (100) nach einem der Ansprüche 1 bis 5, wobei mindestens ein Teil der leitfähigen Bereiche (111) eine planare ringförmige Form aufweist, die ein entsprechendes der Verdrahtungselemente (108) umgibt.

7. Komponententräger (100) nach einem der Ansprüche 1 bis 6, wobei mindestens ein Teil der leitfähigen Bereiche (111) kreisförmig ist und koaxial mit einer Achse eines entsprechenden Verdrahtungselements (108) ausgerichtet ist.

8. Komponententräger (100) nach einem der Ansprüche 1 bis 7, umfassend mindestens eines der folgenden Merkmale:
benachbarte Verdrahtungselemente (108) der elektrisch isolierenden Schichtstruktur (106) weisen unterschiedliche Querschnittsflächen auf;
benachbarte weitere Verdrahtungselemente (108') der anderen elektrisch isolierenden Schichtstruktur (106') weisen die gleichen Querschnittsflächen auf;
weitere Verdrahtungselemente (108'), die mit dem entsprechenden leitfähigen Bereich (111) verbunden sind, weisen andere Querschnittsflächen auf als die weiteren Verdrahtungselemente (108'), die mit dem leitfähigen Bereich (111) verbunden sind, der mit dem benachbarten Verdrahtungselement (108) verbunden ist.

9. Komponententräger (100) nach einem der Ansprüche 1 bis 8, wobei mindestens einer der leitfähigen Bereiche (111) mit mindestens zwei der weiteren Verdrahtungselemente (108') elektrisch verbunden ist.

10. Komponententräger (100) nach einem der Ansprüche 1 bis 9, wobei die weiteren Verdrahtungselemente (108') eine kleinere Abmessung, insbesondere einen kleineren Durchmesser (D1), aufweisen, verglichen mit einer größeren Abmessung, insbesondere einem größeren Durchmesser (D1), der Verdrahtungselemente (108).

11. Komponententräger (100) nach einem der Ansprüche 1 bis 10, umfassend eine Vielzahl von noch anderen Verdrahtungselementen (108"), die in noch einer anderen der mindestens zwei elektrisch isolierenden Schichtstrukturen (106") auf einer gegenüberliegenden Seite der elektrisch isolierenden Schichtstruktur (106) in Bezug auf die andere elektrisch isolierende Schichtstruktur (106') bereitgestellt ist;
wobei einige leitfähige Bereiche (111) mit mindestens einem der Vielzahl von Verdrahtungselementen (108) und mit mindestens einem der Vielzahl von noch anderen Verdrahtungselementen (108") verbunden sind; und
wobei jeder dieser leitfähigen Bereiche (111) durch einen Abstand (d) von einem entsprechenden leitfähigen Bereich (111) beabstandet ist, der mit einem benachbarten Verdrahtungselement (108) verbunden ist, wobei der Abstand (d) mindestens 5 % eines Durchmessers (D1) des Verdrahtungselements (108) beträgt.

12. Verfahren zum Herstellen eines Komponententrägers (100), wobei das Verfahren umfasst:
Bereitstellen eines Stapels (102), umfassend mindestens zwei elektrisch isolierende Schichtstrukturen (106, 106', 106") und mindestens eine elektrisch leitfähige Schichtstruktur (104, 104', 104");
Ausbilden einer Vielzahl von Verdrahtungselementen (108) in einer der mindestens zwei elektrisch isolierenden Schichtstrukturen (106), wobei die Vielzahl von Verdrahtungselementen (108) in einer Verdrahtungsebene (162) angeordnet ist, um Folgendes zu bilden:
eine erste Reihe (110) von äquidistanten Verdrahtungselementen (108), angeordnet
entlang einer geraden Richtung innerhalb der Verdrahtungsebene (162); und
eine zweite Reihe (112) von äquidistanten Verdrahtungselementen (108), die entlang der geraden Richtung innerhalb der Verdrahtungsebene (162) angeordnet sind;
Ausbilden einer Vielzahl von weiteren Verdrahtungselementen (108') in einer anderen der mindestens zwei elektrisch isolierenden Schichtstrukturen (106');
Ausbilden der mindestens einen elektrisch leitfähigen Schichtstruktur (104, 104', 104"), um mehrere leitfähige Bereiche (111) zu umfassen, die elektrisch voneinander isoliert sind, wobei jeder der leitfähigen Bereiche (111) mit mindestens einem der Vielzahl von Verdrahtungselementen (108) und mit mindestens einem der Vielzahl von weiteren Verdrahtungselementen (108') verbunden ist; und
Ausbilden jedes der leitfähigen Bereiche (111) der mindestens einen elektrisch leitfähigen Schichtstruktur (104, 104', 104"), so dass sie durch einen Abstand (d) von einem entsprechenden leitfähigen Bereich (111), der mit einem benachbarten Verdrahtungselement (108, 108') verbunden ist, beabstandet sind, wobei der Abstand (d) mindestens 5 % eines Durchmessers (D1) des Verdrahtungselements (108, 108') beträgt;
**dadurch gekennzeichnet, dass**
eine Anzahl weiterer Verdrahtungselemente (108'), die mit einem entsprechenden leitfähigen Bereich (111) verbunden ist, der mit einem Verdrahtungselement (108) der ersten Reihe (110) verbunden ist, höher ist als eine Anzahl der weiteren Verdrahtungselemente (108'), die mit dem entsprechenden leitfähigen Bereich (111) verbunden ist, der mit einem Verdrahtungselement (108) der zweiten Reihe (112) verbunden ist,
und dadurch, dass
eine Anzahl weiterer Verdrahtungselemente (108'), die mit einem größeren leitfähigen Bereich (111) verbunden ist, höher ist als eine Anzahl weiterer Verdrahtungselemente (108'), die mit einem kleineren leitfähigen Bereich (111) verbunden ist.

## Revendications

1. Support de composant (100), qui comprend :
un empilement (102) d'au moins deux structures de couche électro-isolante (106, 106', 106") et d'au moins une structure de couche électro-conductrice (104, 104', 104") ;
une pluralité d'éléments de câblage (108) fournis dans l'une des au moins deux structures de couche électro-isolante (106), ladite pluralité d'éléments de câblage (108) étant agencée dans un plan de câblage (162) pour former :
une première rangée (110) d'éléments de câblage équidistants (108) agencés le long d'une direction droite dans le plan de câblage (162) ; et
une deuxième rangée (112) d'éléments de câblage équidistants (108) agencés le long de la direction droite dans le plan de câblage (162) ;
une pluralité d'autres éléments de câblage (108') fournis dans une autre des au moins deux structures de couche électriquement isolante (106') ;
dans lequel l'au moins une structure de couche électriquement conductrice (104, 104', 104") comprend plusieurs zones conductrices (111) qui sont électriquement isolées les unes par rapport aux autres, chacune desdites zones conductrices (111) étant connectée à l'au moins un des éléments de câblage (108) et à l'au moins un des autres éléments de câblage (108') ; et
dans lequel chacune des zones conductrices (111) de l'au moins une structure de couche électriquement conductrice (104, 104', 104") est espacée d'une distance (d) d'une zone conductrice respective (111) connectée à un élément de câblage adjacent (108, 108'), dans lequel ladite distance (d) est d'au moins 5 % d'un diamètre (D1) de l'élément de câblage (108, 108') ;
**caractérisé en ce que**
une quantité d'éléments de câblage supplémentaires (108') connectés à une zone conductrice respective (111) qui est connectée à un élément de câblage (108) de la première rangée (110) est supérieure à une quantité d'éléments de câblage supplémentaires (108') connectés à la zone conductrice respective (111) qui est connectée à un élément de câblage (108) de la deuxième rangée (112),
et **en ce que**
une quantité d'éléments de câblage supplémentaires (108') connectés à une zone conductrice plus grande (111) est supérieure à une quantité d'éléments de câblage supplémentaires (108') connectés à une zone conductrice plus petite (111).

2. Support de composants (100) selon la revendication 1, dans lequel les éléments de câblage (108) de la deuxième rangée (112) sont pourvus d'un décalage le long de la direction droite par rapport aux éléments de câblage (108) de la première rangée (110).

3. Support de composants (100) selon l'une quelconque des revendications 1 à 2, dans lequel l'au moins une partie des éléments de câblage (108) sont agencés au niveau de centres de cellules virtuelles hexagonales (126) du plan de câblage (162), chacune desdites cellules virtuelles hexagonales (126) étant adjacente à une autre en partageant un côté respectif d'un hexagone respectif avec un hexagone adjacent respectif.

4. Support de composants (100) selon l'une quelconque des revendications 1 à 3, dans lequel la pluralité d'autres éléments de câblage (108') sont agencés dans un autre plan de câblage (164) parallèle au plan de câblage (162) et selon un motif correspondant, mais avec une densité d'éléments de câblage différente de celle de la première rangée (110) et de la deuxième rangée (112) d'éléments de câblage (108).

5. Support de composant (100) selon l'une quelconque des revendications 1 à 4, dans lequel l'au moins une partie des zones conductrices (111) sont des plages de connexion.

6. Support de composant (100) selon l'une quelconque des revendications 1 à 5, dans lequel l'au moins une partie des zones conductrices (111) ont une forme annulaire plane entourant un élément de câblage (108) respectif.

7. Support de composants (100) selon l'une quelconque des revendications 1 à 6, dans lequel l'au moins une partie des zones conductrices (111) sont circulaires et sont alignées coaxialement avec un axe d'un élément de câblage respectif (108).

8. Support de composants (100) selon l'une quelconque des revendications 1 à 7, comprenant l'au moins une des caractéristiques suivantes :
des éléments de câblage adjacents (108) de ladite structure de couche électriquement isolante (106) ont des surfaces de section transversale différentes ;
des éléments de câblage supplémentaires adjacents (108') de ladite autre structure de couche électriquement isolante (106') ont les mêmes surfaces de section transversale ;
d'autres éléments de câblage (108') connectés à la zone conductrice respective (111) ont des surfaces de section transversale différentes de celles des autres éléments de câblage (108') connectés à la zone conductrice (111) qui est connectée à l'élément de câblage adjacent (108).

9. Support de composants (100) selon l'une quelconque des revendications 1 à 8, dans lequel l'au moins une desdites zones conductrices (111) est connectée électriquement à au moins deux desdits éléments de câblage supplémentaires (108').

10. Support de composants (100) selon l'une quelconque des revendications 1 à 9, dans lequel les éléments de câblage supplémentaires (108') présentent une dimension plus petite, en particulier un diamètre plus petit (D1), par rapport à une dimension plus grande, en particulier un diamètre plus grand (D1), des éléments de câblage (108).

11. Support de composants (100) selon l'une quelconque des revendications 1 à 10, comprenant une pluralité d'autres éléments de câblage (108") encore prévus dans encore une autre des au moins deux structures de couche électriquement isolantes (106") sur un côté opposé de ladite structure de couche électriquement isolante (106) en relation avec ladite autre structure de couche électriquement isolante (106') ;
dans lequel certaines zones conductrices (111) sont connectées à l'au moins un des éléments de la pluralité d'éléments de câblage (108) et à l'au moins un des éléments de la pluralité d'autres éléments de câblage (108") encore ; et
dans lequel chacune desdites zones conductrices (111) est espacée d'une distance (d) d'une zone conductrice respective (111) connectée à un élément de câblage adjacent (108), et dans lequel ladite distance (d) est d'au moins 5 % d'un diamètre (D1) de l'élément de câblage (108).

12. Procédé de fabrication d'un support de composants (100), dans lequel le procédé comprend :
la fourniture d'un empilement (102) d'au moins deux structures de couche électro-isolante (106, 106', 106") et d'au moins une structure de couche électro-conductrice (104, 104', 104") ;
la formation d'une pluralité d'éléments de câblage (108) dans l'une des au moins deux structures de couche électriquement isolante (106), ladite pluralité d'éléments de câblage (108) étant agencée dans un plan de câblage (162) pour former :
une première rangée (110) d'éléments de câblage (108) équidistants agencés
le long d'une direction droite dans le plan de câblage (162) ; et
une deuxième rangée (112) d'éléments de câblage équidistants (108) agencés le long de la direction droite dans le plan de câblage (162) ;
la formation d'une pluralité d'éléments de câblage supplémentaires (108') dans une autre des au moins deux structures de couche électriquement isolante (106') ;
la formation d'au moins une structure de couche électriquement conductrice (104, 104', 104") de manière à comprendre plusieurs zones conductrices (111) électriquement isolées les unes par rapport aux autres, chacune desdites zones conductrices (111) étant connectée à l'au moins un des éléments de la pluralité d'éléments de câblage (108) et à l'au moins un des éléments de la pluralité d'éléments de câblage supplémentaires (108') ; et
la formation de chacune des zones conductrices (111) d'au moins une structure de couche électriquement conductrice (104, 104', 104") de manière à être espacée d'une distance (d) d'une zone conductrice respective (111) connectée à un élément de câblage adjacent (108, 108'), et dans lequel ladite distance (d) est d'au moins 5 % d'un diamètre (D1) de l'élément de câblage (108, 108') ;
**caractérisé en ce que**
une quantité d'éléments de câblage supplémentaires (108') connectés à une zone conductrice respective (111) qui est connectée à un élément de câblage (108) de la première rangée (110) est supérieure à une quantité d'éléments de câblage supplémentaires (108') connectés à la zone conductrice respective (111) qui est connectée à un élément de câblage (108) de la deuxième rangée (112),
et **en ce que**
une quantité d'éléments de câblage supplémentaires (108') connectés à une zone conductrice plus grande (111) est supérieure à une quantité d'éléments de câblage supplémentaires (108') connectés à une zone conductrice plus petite (111).
